# EUROPEAN PATENT APPLICATION

(11) **EP 4 679 989 A1**
(43) Date of publication of application: **14.01.2026**
(21) Application number: 25189099.2
(22) Date of filing: 11.07.2025
(51) Int. Cl.: H10K 59/122, H10K 59/131, H10K 59/80

(54) **DISPLAY PANEL HAVING SEPARATORS AND ELECTRONIC DEVICE INCLUDING THE SAME**

(30) Priority: 12.07.2024 KR 20240092555
(71) Applicant: Samsung Display Co., Ltd., Yongin-si, Gyeonggi-do (KR)
(72) Inventor: PARK, Juchan, Yongin-si (KR); KO, Yoomin, Yongin-si (KR); KIM, Sunho, Yongin-si (KR)
(74) Representative: Marks & Clerk LLP

(57) **Abstract**

A display panel includes a driving element layer including a pixel driver, a light-emitting element on the driving element layer and including a lower electrode, an intermediate layer including at least a light-emitting layer, and a upper electrode, a pixel defining film on the driving element layer, a connection electrode formed of a conductive material on the pixel defining film and electrically connected to the pixel driver and the upper electrode, a first separator on the pixel defining film adjacent to the light-emitting element, and a second separator on the pixel defining film and spaced apart from the first separator, wherein the first separator includes a first side surface adjacent to the light-emitting element and a second side surface facing the second separator, and the first connection electrode is disposed on at least a portion of the first side surface, and the conductive material exposes the second side surface.

## Description

### BACKGROUND

### 1. Technical Field

The present disclosure herein relates to a display panel having a plurality of separators and an electronic device having the same.

### 2. Discussion of Related Art

Multimedia electronic devices such as televisions, mobile phones, tablets, computers, navigation systems, and game consoles may be equipped with a display panel for displaying images. The display panel may include a light-emitting element and a circuit for driving the light-emitting element. Light-emitting elements included in the display panel emit light and generate images according to a voltage applied from the circuit.

### SUMMARY

The present disclosure provides a display panel having improved contact reliability, reduced color mixing between adjacent pixels, and reduced luminance degradation.

The invention provides a display panel including, a driving element layer including a pixel driver, a first light-emitting element disposed on the driving element layer and including, a first lower electrode, a first intermediate layer disposed on the first lower electrode and including at least a first light-emitting layer, and a first upper electrode disposed on the first intermediate layer, a pixel defining film disposed on the driving element layer and having a first opening defined therein and exposing at least a portion of the first lower electrode, a first connection electrode formed of a conductive material and disposed on the pixel defining film and electrically connected to the pixel driver and the first upper electrode, a first separator disposed on the pixel defining film and adjacent to the first light-emitting element, and a second separator disposed on the pixel defining film and spaced apart from the first light-emitting element. The first separator includes a first side surface adjacent to the first light-emitting element and a second side surface facing the second separator. The first connection electrode is disposed on at least a portion of the first side surface, and the conductive material exposes the second side surface.

In an embodiment of the inventive concept, a display panel may further include, a second light-emitting element disposed on the driving element layer and including, a second lower electrode, a second intermediate layer disposed on the second lower electrode and including at least a second light-emitting layer, and a second upper electrode disposed on the second intermediate layer. The second separator may be disposed between the second light-emitting element and the first separator on a plane.

In an embodiment, a second opening exposing at least a portion of the second lower electrode may be defined in the pixel defining film. The display panel may further include a second connection electrode formed of the conductive material, disposed on the pixel defining film and electrically connected to the pixel driver and the second upper electrode.

In an embodiment, the second separator may include a third side surface adjacent to the second light-emitting element and a fourth side surface facing the first separator. The second connection electrode may be disposed on at least a portion of the third side surface, the conductive material exposes the fourth side surface, and the conductive material exposes a spacer portion disposed between the first separator and the second separator. Each of the first connection electrode and the second connection electrode define a spacer portion between the first separator and the second separator.

In an embodiment, the first intermediate layer may further include a first functional layer. The first functional layer may include a first intermediate functional layer disposed on the first lower electrode and a second intermediate functional layer disposed on the first light-emitting layer, and the first light-emitting layer may be disposed between the first intermediate functional layer and the second intermediate functional layer.

In an embodiment, the display panel may further include a first dummy layer disposed on the first separator and including the same material as the first functional layer and a second dummy layer disposed on the first dummy layer and including the same material as the first upper electrode. The first connection electrode may be in contact with the second dummy layer.

In an embodiment, the display panel may further include a first additional dummy layer disposed in a spacer portion defined between the first separator and the second separator and including the same material as the first functional layer and a second additional dummy layer disposed on the first additional dummy layer and including the same material as the first upper electrode.

In an embodiment, the first connection electrode may have a ring shape surrounding the first opening.

In an embodiment, in a first contact region adjacent to the first separator, the lower surface of the first upper electrode may be in contact with the upper surface of the first connection electrode.

In an embodiment, the first connection electrode may include a first connection portion disposed in the first contact region, a second connection portion disposed on the first side surface of the first separator, and a third connection portion disposed on the upper surface of the separator.

In an embodiment, the first upper electrode may include a first upper electrode portion in contact with the upper surface of the first connection portion and a second upper electrode portion in contact with a side surface of the second connection portion.

In an embodiment, the display panel may further include an additional separator disposed between the first separator and the second separator. The additional separator may be spaced apart from each of the first separator and the second separator.

In an embodiment, a through hole may be defined in the pixel defining film, and the first connection electrode may be connected to the pixel driver through the through hole.

In an embodiment, the first intermediate layer may overlap the through hole.

In an embodiment, in an intermediate region disposed between the first separator and the first light-emitting element, the first intermediate layer may be disposed between the first connection electrode and the first upper electrode.

In another aspect of the inventive concept, a display panel includes: a driving element layer including a pixel driver; a first light-emitting element disposed on the driving element layer and including, a first lower electrode, a first intermediate layer disposed on the first lower electrode and including at least a first light-emitting layer, and a first upper electrode disposed on the first intermediate layer; a second light-emitting element disposed on the driving element layer and including a second lower electrode, a second intermediate layer disposed on the second lower electrode and including at least a second light-emitting layer, and a second upper electrode disposed on the second intermediate layer; a pixel defining film disposed on the driving element layer and having a first opening defined therein and exposing at least a portion of the first lower electrode and a second opening defined therein and exposing at least a portion of the second lower electrode; a first connection electrode disposed on the pixel defining film and electrically connected to the pixel driver and the first upper electrode; a second connection electrode disposed on the pixel defining film and electrically connected to the pixel driver and the second upper electrode; and a separator disposed on the pixel defining film and including a first separator adjacent to the first light-emitting element and a second separator adjacent to the second light-emitting element. A separation distance between the first separator and the second separator is smaller than a separation distance between the first connection electrode and the second connection electrode.

In an embodiment, the first intermediate layer may further include a first functional layer. The first functional layer may include a first intermediate functional layer disposed on the first lower electrode and a second intermediate functional layer disposed on the first light-emitting layer, and the first light-emitting layer may be disposed between the first intermediate functional layer and the second intermediate functional layer. The second intermediate layer may further include a second functional layer. The second functional layer may include a third intermediate functional layer disposed on the second lower electrode and a fourth intermediate functional layer disposed on the second light-emitting layer, and the second light-emitting layer may be disposed between the third intermediate functional layer and the fourth intermediate functional layer.

In an embodiment, the display panel may further include a first dummy layer disposed on the first separator and including the same material as the first functional layer, a second dummy layer disposed on the first dummy layer and including the same material as the first upper electrode, a third dummy layer disposed on the second separator and including the same material as the second functional layer, and a fourth dummy layer disposed on the third dummy layer and including the same material as the second upper electrode. The first connection electrode may be in contact with the second dummy layer, and the second connection electrode may be in contact with the fourth dummy layer.

In an embodiment, a separation distance between the second dummy layer and the fourth dummy layer may be greater than a separation distance between the first connection electrode and the second connection electrode, and the separation distance the first connection electrode and the second connection electrode may be less than a separation distance between an outer side surface of the first separator and an outer side surface of the second separator.

In an embodiment, each of the first connection electrode and the second connection electrode may be formed of a conductive material that may not be disposed in a spacer portion between the first separator and the second separator.

In an embodiment, the display panel may further include a first additional dummy layer disposed between the first separator and the second separator and including the same material as each of the first functional layer and the third functional layer and a second additional dummy layer disposed on the first additional dummy layer and including the same material as each of the first upper electrode and the second upper electrode.

In another aspect an electronic device includes: a processor; a memory having stored application programs for execution by the processor; a display device including a driving element layer including a pixel driver; a first light-emitting element disposed on the driving element layer and including a first lower electrode, a first intermediate layer disposed on the first lower electrode and including at least a first light-emitting layer, and a first upper electrode disposed on the first intermediate layer; a second light-emitting element disposed on the driving element layer and including a second lower electrode, a second intermediate layer disposed on the second lower electrode and including at least a second light-emitting layer, and a second upper electrode disposed on the second intermediate layer; a pixel defining film disposed on the driving element layer and having a first opening defined therein and exposing at least a portion of the first lower electrode and a second opening defined therein and exposing at least a portion of the second lower electrode; a connection electrode disposed on the pixel defining film and electrically connected to the pixel driver; a first separator disposed on the pixel defining film and adjacent to the first light-emitting element; and a second separator disposed on the pixel defining film and spaced apart from the first separator, wherein a spacer portion is provided between the first separator and the second separator, and the connection electrode is not disposed between the first separator and the second separator; and an user interface configured to sense user input via touch or cursor select of an icon presented on the display device, wherein the processor is caused to execute one or more of the stored application programs upon receipt of the user input.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a block diagram of a display device according to an embodiment of the inventive concept;
FIG. 2A is an equivalent circuit diagram of a pixel according to an embodiment of the inventive concept;
FIG. 2B is an equivalent circuit diagram of a pixel according to an embodiment of the inventive concept;
FIG. 2C is an equivalent circuit diagram of a pixel according to an embodiment of the inventive concept;
FIG. 3A is a plan view schematically illustrating a display panel according to an embodiment of the inventive concept;
FIG. 3B is a plan view schematically illustrating the display panel according to an embodiment of the inventive concept;
FIG. 4A is an enlarged plan view of a partial region of the display panel according to an embodiment of the inventive concept;
FIG. 4B is an enlarged plan view of a partial region of the display panel according to an embodiment of the inventive concept;
FIG. 4C is an enlarged plan view of a partial region of the display panel according to an embodiment of the inventive concept;
FIG. 4D is an enlarged plan view of a partial region of the display panel according to an embodiment of the inventive concept;
FIG. 5 is a cross-sectional view of the display panel according to an embodiment of the inventive concept;
FIG. 6 is a cross-sectional view of the display panel according to an embodiment of the inventive concept;
FIG. 7A and FIG. 7B are enlarged cross-sectional views of a partial region of the display panel according to an embodiment of the inventive concept; and
FIG. 8A, FIG. 8B, and FIG. 8C are enlarged cross-sectional views of a partial region of a display panel according to an embodiment of the inventive concept.
FIG. 9 is a diagram illustrating an electronic device according to an embodiment of the present invention.

### DETAILED DESCRIPTION

In this specification, it will be understood that when an element (or region, layer, portion, etc.) is referred to as being "on", "connected to" or "coupled to" another element, the element can be directly on, connected or coupled to another element, or intervening elements may be present.

Like reference numerals refer to like elements throughout. In addition, in the drawings, the thicknesses, ratios, and dimensions of elements may be exaggerated for effective description of the technical contents. As used herein, the term "and/or" includes any and all combinations that the associated configurations can define.

It will be understood that, although the terms first, second, etc. may be used herein to describe various elements, these elements should not be limited by these terms. These terms are only used to distinguish elements from each other. For example, a first element could be termed a second element without departing from the scope of the present invention. Similarly, the second element may also be referred to as the first element. The terms of a singular form include plural forms unless otherwise specified.

In addition, terms, such as "below", "lower", "above", "upper" and the like, are used herein for ease of description to describe an element's relation to another element(s) as illustrated in the figures. The above terms are relative concepts and are described based on the directions indicated in the drawings.

It will be understood that the terms "include" and/or "have", when used in this specification, specify the presence of stated features, integers, steps, operations, elements, components and/or groups thereof, but do not preclude the presence or addition of one or more other features, integers, steps, operations, elements, components, and/or groups thereof.

The term "part" or "unit" refers to a software component or hardware component that performs a specific function. The hardware component may include, for example, a field-programmable gate array (FPGA) or an application-specific integrated circuit (ASIC). The software component may refer to an executable code and/or data used by the executable code in an addressable storage medium. Accordingly, the software components may be, for example, object-oriented software components, class components, and task components, and may include processes, functions, attributes, procedures, subroutines, program code segments, drivers. firmware, micro codes, circuits, data, databases, data structures, tables, arrays or variables.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the inventive concept will be described with reference to the drawings.

According to some embodiments, a display panel may be provided having improved contact reliability, reduced color mixing between adjacent pixels, and reduced luminance degradation. The display panel may include a first separator adjacent to a first light-emitting element and a second separator spaced apart from the first separator, wherein a first connection electrode may be disposed on at least a portion of a first side surface of the first separator that is adjacent to the first light-emitting element, and the conductive material exposes a second side surface of the first separator.

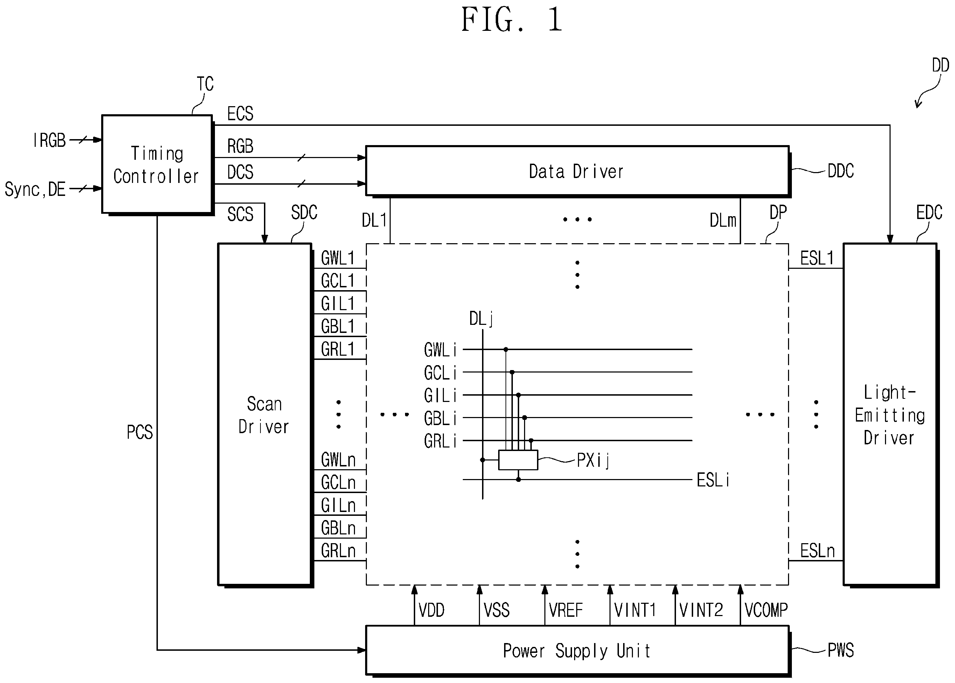

FIG. 1 is a block diagram of a display device DD according to an embodiment of the inventive concept.

Referring to FIG. 1, the display device DD may include a display panel DP, a panel driving unit SDC, EDC, and DDC, a power supply unit PWS, and a timing controller TC. According to an embodiment, the display panel DP is described as a light-emitting display panel. The light-emitting display panel may include an organic light-emitting display panel, an inorganic light-emitting display panel, or a quantum dot light-emitting display panel. In some embodiments, the organic light-emitting display panel will be described in detail as an example. The panel driving unit SDC, EDC, and DDC may include a scan driver SDC, a light-emitting driver EDC, and a data driver DDC. The display device DD be a multimedia electronic device such as a television, a mobile phone, a tablet, a computer, a navigation device, a game console, and the like.

The display panel DP may include scan lines GWL1 to GWLn, GCL1 to GCLn, GIL1 to GILn, GBL1 to GBLn, and GRL1 to GRLn, light-emitting lines ESL1 to ESLn, and data lines DL1 to DLm. The display panel DP may include a plurality of pixels connected to the scan lines GWL1 to GWLn, GCL1 to GCLn, GIL1 to GILn, GBL1 to GBLn, and GRL1 to GRLn, the light-emitting lines ESL1 to ESLn, and the data lines DL1 to DLm (wherein m and n are integers greater than 1).

For example, a pixel PXij (i and j are integers greater than 1) located on an i-th horizontal line (or an i-th pixel row) and a j-th vertical line (or a j-th pixel column) may be connected to an i-th first scan line GWLi (or write scan line), an i-th second scan line GCLi (or compensation scan line), an i-th third scan line GILi (or first initialization scan line), an i-th fourth scan line GBLi (or second initialization scan line), an i-th fifth scan line GRLi (or reset scan line), a j-th data line DLj, and an i-th light-emitting line ESLi.

The pixel PXij may include a plurality of light-emitting elements, a plurality of transistors, and a plurality of capacitors. The pixel PXij may receive, through the power supply unit PWS, a first power voltage VDD, a second power voltage VSS, a third power voltage VREF (or reference voltage), a fourth power voltage VINT1 (or first initialization voltage), a fifth power voltage VINT2 (or second initialization voltage), and a sixth power voltage VCOMP (or compensation voltage).

The voltage values of the first power voltage VDD and the second power voltage VSS may be set so that current can flow into a light-emitting element so as to emit light. For example, the first power voltage VDD may be set to a higher voltage than the second power voltage VSS.

The third power voltage VREF may be a voltage for initializing a gate of a driving transistor included in the pixel PXij. The third power voltage VREF may be used to implement a predetermined gradation by using a voltage difference between a data signal and the third power voltage VREF. To this end, the third power voltage VREF may be set to a predetermined voltage within the voltage range of the data signal.

The fourth power voltage VINT1 may be a voltage for initializing a capacitor included in the pixel PXij. The fourth power voltage VINT1 may be set to a voltage lower than the third power voltage VREF. For example, the fourth power voltage VINT1 may be set to a voltage lower than a difference between the third power voltage VREF and a threshold voltage of the driving transistor. However, embodiments of the inventive concept are not limited thereto.

The fifth power voltage VINT2 may be a voltage for initializing the cathode of the light-emitting element included in the pixel PXij. The fifth power voltage VINT2 may be set to a voltage lower than the first power voltage VDD or the fourth power voltage VINT1, or may be set to a voltage similar to or equal to the third power voltage VREF, but embodiments of the inventive concept are not limited thereto, and the fifth power voltage VINT2 may be set to a voltage similar to or equal to the first power voltage VDD.

The sixth power voltage VCOMP may supply a predetermined current to the driving transistor when compensating for the threshold voltage of the driving transistor.

Meanwhile, FIG. 1 illustrates that the first to sixth power voltages VDD, VSS, VREF, VINT1, VINT2, and VCOMP may be supplied from the power supply unit PWS, but embodiments of the inventive concept are not limited thereto. For example, the first power voltage VDD and the second power voltage VSS may be supplied regardless of the structure of the pixel PXij, and at least one of the third power voltage VREF, the fourth power voltage VINT1, the fifth power voltage VINT2 and the sixth power voltage VCOMP may not be supplied according to the structure of the pixel PXij.

In an embodiment of the inventive concept, signal lines connected to the pixel PXij may be set in various ways according to a circuit structure of the pixel PXij.

The scan driver SDC may receive a first control signal SCS from the timing controller TC and, based on the first control signal SCS, supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The scan signal may be set to a voltage at which transistors that receive the scan signal may be turned on. For example, a scan signal supplied to a P-type transistor may be set to a logic low level, and a scan signal supplied to an N-type transistor may be set to a logic high level. Hereinafter, the expression "a scan signal is supplied" can be understood as meaning that the scan signal is supplied at a logic level that turns on the transistor controlled by the scan signal.

FIG. 1 illustrates, for the convenience of explanation, that the scan driver SDC is a single element, but embodiments of the inventive concept are not limited thereto. According to an embodiment of the inventive concept, a plurality of scan drivers may be included to supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The light-emitting driver EDC may supply a light-emitting signal to the light-emitting lines ESL1 to ESLn, based on a second control signal ECS. For example, the light-emitting signal may be sequentially supplied to the light-emitting lines ESL1 to ESLn.

Transistors connected to the light-emitting lines ESL1 to ESLn according to an embodiment of the inventive concept may be composed of N-type transistors. In this case, the light-emitting signal supplied to the light-emitting lines ESL1 to ESLn may be set to a gate-off voltage. Transistors, which receive the light-emitting signal, may be turned off when the light-emitting signal is supplied, and in cases other than that, the transistors may be set to a state in which they are turned on.

The second control signal ECS may include a light-emitting start signal and clock signals, and the light-emitting driver EDC may be implemented as a shift register which sequentially generates and outputs the light-emitting signal in a pulse form by sequentially shifting the light-emitting start signal in a pulse form with the use of the clock signals.

The data driver DDC may receive a third control signal DCS and image data RGB from the timing controller TC. The data driver DDC may convert the image data RGB in digital form into an analog data signal (i.e., a data signal). The data driver DDC may supply a data signal to the data lines DL1 to DLm in response to the third control signal DCS.

The third control signal DCS may include a data enable signal, a horizontal start signal, a data clock signal, and the like which command the output of a valid data signal. For example, the data driver DDC may include a shift register configured to generate a sampling signal by shifting the horizontal start signal in synchronization with the data clock signal, a latch configured to latch the image data RGB in response to the sampling signal, a digital-to-analog converter (or decoder) configured to convert the latched image data (e.g., data in digital form) into data signals in analog form, and buffers (or amplifiers) configured to output the data signals to the data lines DL1 to DLm.

The power supply unit PWS may supply the display panel DP with the first power voltage VDD, the second power voltage VSS, and the third power voltage VREF for driving the pixel PXij. In addition, the power supply unit PWS may supply the display panel DP with at least one of the fourth power voltage VINT1, the fifth power voltage VINT2, or the sixth power voltage VCOMP.

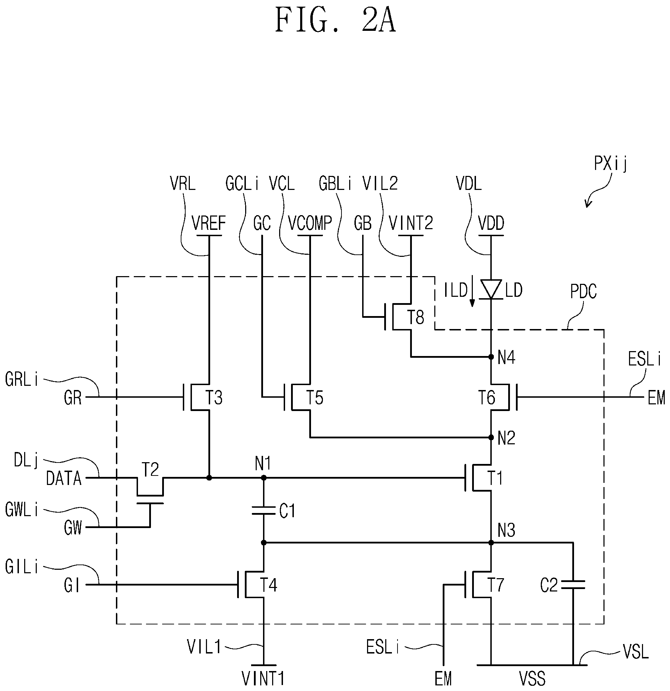

For example, the power supply unit PWS may supply the display panel DP with the first power voltage VDD, the second power voltage VSS, the third power voltage VREF, the fourth power voltage VINT1, the fifth power voltage VINT2, and the sixth power voltage VCOMP respectively via a first power line VDL (see FIG. 2A), a second power line VSL (see FIG. 2A), a third power line VRL (or reference voltage line, see FIG. 2A), a fourth power line VIL1 (or first initialization voltage line, see FIG. 2A), a fifth power line VIL2 (or second initialization voltage line, see FIG. 2A), and a sixth power line VCL (or compensation voltage line, see FIG. 2A) which are not illustrated.

The power supply unit PWS may be implemented as a power management integrated circuit, but embodiments of the inventive concept are not limited thereto.

The timing controller TC may generate a first control signal SCS, a second control signal ECS, a third control signal DCS, and a fourth control signal PCS, based on an input image data IRGB, a sync signal Sync (e.g., a vertical sync signal, a horizontal sync signal, etc.), a data enable signal DE, a clock signal, and the like. The first control signal SCS may be supplied to the scan driver SDC, the second control signal ECS may be supplied to the light-emitting driver EDC, the third control signal DCS may be supplied to the data driver DDC, and the fourth control signal PCS may be supplied to the power supply unit PWS. The timing controller TC may rearrange the input image data so as to correspond to the arrangement of the pixels PXij in the display panel DP to generate image data RGB (or frame data).

Meanwhile, the scan driver SDC, the light-emitting driver EDC, the data driver DDC, the power supply unit PWS, and/or the timing controller TC may be formed directly on the display panel DP or provided in the form of a separate driving chip and connected to the display panel DP. In addition, at least two of the scan driver SDC, the light-emitting driver EDC, the data driver DDC, the power supply unit PWS, and the timing controller TC may be provided as a driving chip. For example, the data driver DDC and the timing controller TC may be provided as a driving chip.

The display device DD according to an embodiment of the inventive concept has been described with reference to FIG. 1, but the display device according to this inventive concept is not limited thereto. More signal lines may be added or some signal lines may be omitted according to the configuration of the pixels. In addition, a connection relationship between a pixel and signal lines may be changed. When any one of the signal lines is omitted, another signal line may substitute for the omitted signal line.

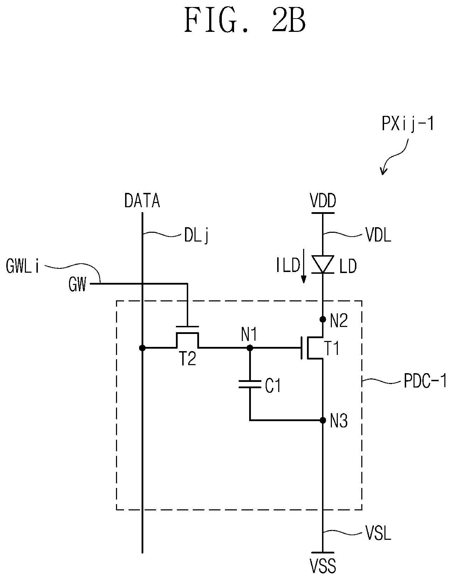

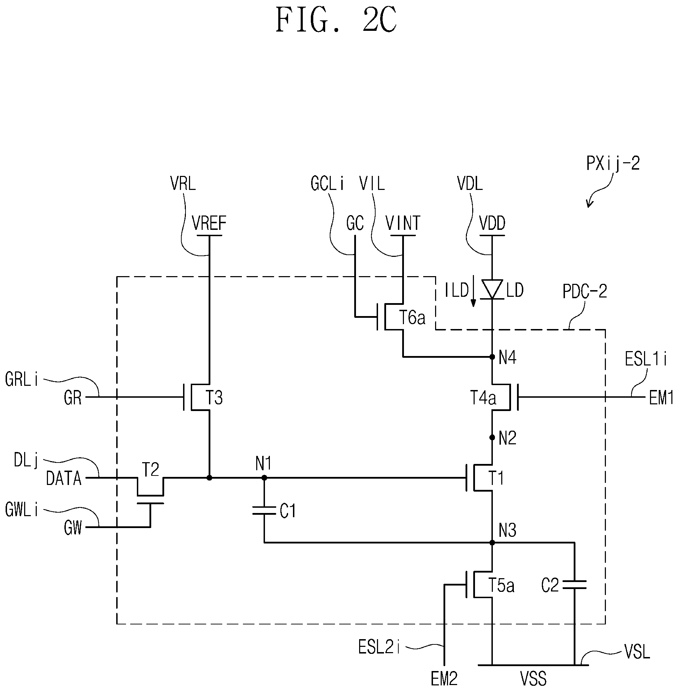

FIGS. 2A, 2B, and 2C are equivalent circuit diagrams of pixels according to an embodiment of the inventive concept. As examples, FIGS. 2A, 2B, and 2C respectively illustrate the equivalent circuit diagrams of pixels PXij, PXij-1, and PXij-2 connected to an i-th first scan line GWLi (hereinafter referred to as a first scan line) and connected to a j-th data line DLj (hereinafter referred to as a data line).

As illustrated in FIG. 2A, the pixel PXij includes a light-emitting element LD and a pixel driver PDC. The light-emitting element LD is connected to the first power line VDL and the pixel driver PDC.

The pixel driver PDC may be connected to a plurality of scan lines GWLi, GCLi, GILi, GBLi, and GRLi, a data line DLj, a light-emitting line ESLi, and a plurality of power voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, as an example, all of the first to eighth transistors T1, T2, T3, T4, T5, T6, T7, and T8 will be described as N-type transistors. However, embodiments of the inventive concept are not limited thereto, and some of the first to eighth transistors T1 to T8 may be N-type transistors and the others thereof may be P-type transistors, and all of the first to eighth transistors T1 to T8 may be P-type transistors, and the inventive concept is not limited to any one embodiment.

The gate of the first transistor T1 may be connected to a first node N1. The first electrode of the first transistor T1 may be connected to a second node N2, and the second electrode thereof may be connected to a third node N3. The first transistor T1 may be a driving transistor. The first transistor T1 may control a driving current ILD flowing from the first power line VDL to the second power line VSL via the light-emitting element LD in response to a voltage of the first node N1. In this case, the first power voltage VDD may be set to a voltage having a higher potential than the second power voltage VSS.

In this specification, the expression "A transistor and a signal line, or a transistor and a transistor are electrically connected to each other" means that the source, drain, and gate of a transistor may have an integrated shape with the signal line, or they may be connected to each other through a connection electrode.

The second transistor T2 may include a gate connected to the write scan line GWLi, a first electrode connected to the data line DLj, and a second electrode connected to the first node N1. The second transistor T2 may supply a data signal DATA to the first node N1 in response to a write scan signal GW transmitted through the write scan line GWLi. When the write scan signal GW is supplied to the write scan line GWLi, the second transistor T2 may be turned on to electrically connect the data line DLj and the first node N1 to each other.

The third transistor T3 may be connected between the first node N1 and the reference voltage line VRL. The first electrode of the third transistor T3 may receive the reference voltage VREF through the reference voltage line VRL, and the second electrode of the third transistor T3 may be connected to the first node N1. According to an embodiment, the gate of the third transistor T3 may receive a reset scan signal GR through the i-th fifth scan line GRLi (hereinafter referred to as a reset scan line). When the reset scan signal GR is supplied to the reset scan line GRLi, the third transistor T3 may be turned on to provide the reference voltage VREF to the first node N1.

The fourth transistor T4 may be connected between the third node N3 and the first initialization voltage line VIL1. The first electrode of the fourth transistor T4 may be connected to the third node N3, and the second electrode of the fourth transistor T4 may be connected to the first initialization voltage line VIL1 that provides the first initialization voltage VINT1. The fourth transistor T4 may be referred to as a first initialization transistor. The gate of the fourth transistor T4 may receive a first initialization scan signal GI through the i-th third scan line GILi (hereinafter referred to as a first initialization scan line). When the first initialization scan signal GI is supplied to the first initialization scan line GILi, the fourth transistor T4 may be turned on to supply the first initialization voltage VINT1 to the third node N3.

The fifth transistor T5 may be connected between the compensation voltage line VCL and the second node N2. The first electrode of the fifth transistor T5 may receive the compensation voltage VCOMP through the compensation voltage line VCL, and the second electrode of the fifth transistor T5 may be connected to the second node N2 to be electrically connected to the first electrode of the first transistor T1. The gate of the fifth transistor T5 may receive a compensation scan signal GC through the i-th second scan line GCLi (hereinafter referred to as a compensation scan line). When the compensation scan signal GC is supplied to the compensation scan line GCLi, the fifth transistor T5 may be turned on to provide the compensation voltage VCOMP to the second node N2, and during a compensation period, a threshold voltage of the first transistor T1 may be compensated for.

The sixth transistor T6 may be connected between the first transistor T1 and the light-emitting element LD. Specifically, the gate of the sixth transistor T6 may receive a light-emitting signal EM through the i-th light-emitting line ESLi (hereinafter referred to as a light-emitting line). The first electrode of the sixth transistor T6 may be connected to the cathode of the light-emitting element LD through a fourth node N4, and the second electrode of the sixth transistor T6 may be connected to the first electrode of the first transistor T1 through the second node N2. The sixth transistor T6 may be referred to as a first light-emitting control transistor. When the light-emitting signal EM is supplied to the light-emitting line ESLi, the sixth transistor T6 may be turned on to electrically connect the light-emitting element LD and the first transistor T1 to each other.

The seventh transistor T7 may be connected between the second power line VSL and the third node N3. The first electrode of the seventh transistor T7 may be connected to the second electrode of the first transistor T1 through the third node N3, and the second electrode of the seventh transistor T7 may receive the second power voltage VSS through the second power line VSL. The gate of the seventh transistor T7 may be electrically connected to the light-emitting line ESLi. The seventh transistor T7 may be referred to as a second light-emitting control transistor. When the light-emitting signal EM is supplied to the light-emitting line ESLi, the seventh transistor T7 may be turned on to electrically connect the second electrode of the first transistor T1 and the second power line VSL to each other.

Meanwhile, according to an embodiment, the sixth transistor T6 and the seventh transistor T7 are illustrated as being connected to the same light-emitting line ESLi and turned on by a same light-emitting signal EM, but this is illustrated as an example, and the sixth transistor T6 and the seventh transistor T7 may be independently turned on by different signals that are distinguished from each other. In addition, in the pixel driver PDC according to an embodiment of the inventive concept, the sixth transistor T6 or the seventh transistor T7 may be omitted.

The eighth transistor T8 may be connected between the second initialization voltage line VIL2 and the fourth node N4. That is, the eighth transistor T8 may include: a gate connected to the i-th fourth scan line GBLi (hereinafter referred to as a second initialization scan line); a first electrode connected to the second initialization voltage line VIL2; and a second electrode connected to the fourth node N4. The eighth transistor T8 may be referred to as a second initialization transistor. The eighth transistor T8 may supply the second initialization voltage VINT2 to the fourth node N4 corresponding to the cathode of the light-emitting element LD in response to a second initialization scan signal GB transmitted through the second initialization scan line GBLi. The cathode of the light-emitting element LD may be initialized by the second initialization voltage VINT2.

Meanwhile, according to an embodiment, some of the second to eighth transistors T2, T3, T4, T5, T6, T7, and T8 may be simultaneously turned on by a same scan signal. For example, the eighth transistor T8 and the fifth transistor T5 may be simultaneously turned on by a same scan signal. For example, the eighth transistor T8 and the fifth transistor T5 may be operated by a same compensation scan signal GC. The eighth transistor T8 and the fifth transistor T5 may be simultaneously turned on/off by a same compensation scan signal GC. In this case, the compensation scan line GCLi and the second initialization scan line GBLi may be provided substantially as a single scan line. Accordingly, the initialization of the cathode of the light-emitting element LD and the compensation of the threshold voltage of the first transistor T1 may be performed at the same time. However, this is illustrated as an example and the inventive concept is not limited to any one embodiment.

In addition, according to this inventive concept, the initialization of the cathode of the light-emitting element LD and the compensation of the threshold voltage of the first transistor T1 may be performed by applying a same power voltage. For example, the compensation voltage line VCL and the second initialization voltage line VIL2 may be provided substantially as a single power voltage line. In this case, the initialization operation of the cathode and the compensation operation of the driving transistor may be performed by a power voltage, and thus designing the driver may be simplified. However, this is illustrated as an example, and the inventive concept is not limited to any one embodiment.

The first capacitor C1 may be disposed between the first node N1 and the third node N3. The first capacitor C1 may store a difference voltage between the first node N1 and the third node N3. The first capacitor C1 may be referred to as a storage capacitor.

The second capacitor C2 may be disposed between the third node N3 and the second power line VSL. That is, an electrode of the second capacitor C2 may be connected to the second power line VSL that receives the second power voltage VSS, and the other electrode of the second capacitor C2 may be connected to the third node N3. The second capacitor C2 may store a charge corresponding to a voltage difference between the second power voltage VSS and the third node N3. The second capacitor C2 may be referred to as a hold capacitor. The second capacitor C2 may have a higher storage capacity than the first capacitor C1. Accordingly, the second capacitor C2 may reduce or minimize, a voltage change of the third node N3 in response to a voltage change of the first node N1.

According to an embodiment, the light-emitting element LD may be connected to the pixel driver PDC through the fourth node N4. The light-emitting element LD may include an anode connected to the first power line VDL and a cathode opposite to the anode. According to an embodiment, the light-emitting element LD may be connected to the pixel driver PDC through the cathode. That is, in the pixel PXij according to this inventive concept, a connection node to which the light-emitting element LD and the pixel driver PDC may be connected may be the fourth node N4, and the fourth node N4 may correspond to a connection node between the first electrode of the sixth transistor T6 and the cathode of the light-emitting element LD. Accordingly, the potential of the fourth node N4 may substantially correspond to the potential of the cathode of the light-emitting element LD.

Specifically, the anode of the light-emitting element LD may be connected to the first power line VDL so that the first power voltage VDD which is a constant voltage is applied, and the cathode thereof may be connected to the first transistor T1 through the sixth transistor T6. That is, according to an embodiment in which the first to eighth transistors T1 to T8 may be N-type transistors, the potential of the third node N3 corresponding to the source of the first transistor T1, which is the driving transistor, may not be directly affected by the characteristics of the light-emitting element LD. Therefore, although degradation of the light-emitting element LD occurs, an effect on a gate-source voltage Vgs of the transistors constituting the pixel driver PDC, particularly the driving transistor, may be reduced. That is, in a case that the amount of change in driving current due to degradation of the light-emitting element LD may be reduced, the afterimage defects of the display panel due to increased usage time may be reduced and the lifespan of the display panel may be improved.

Alternatively, as illustrated in FIG. 2B, the pixel PXij-1 may include a pixel driver PDC-1 including two transistors T1 and T2 and a capacitor C1. The pixel driver PDC-1 may be connected to a light-emitting element LD, a write scan line GWLi, a data line DLj, and a second power line VSL. The pixel driver PDC-1 illustrated in FIG. 2B may correspond to the pixel driver PDC illustrated in FIG. 2A, from which the third to eighth transistors T3 to T8 and the second capacitor C2 are omitted.

Each of the first and second transistors T1 and T2 may be an N-type or P-type transistor. According to an embodiment, each of the first and second transistors T1 and T2 will be exemplarily described as an N-type transistor.

The first transistor T1 may include a gate connected to a first node N1, a first electrode connected to a second node N2, and a second electrode connected to a third node N3. The second node N2 may be connected to the first power line VDL side, and the third node N3 may be connected to the second power line VSL side. The first transistor T1 is connected to the light-emitting element LD through the second node N2 and connected to the second power line VSL through the third node N3. The first transistor T1 may be a driving transistor.

The second transistor T2 may include a gate configured to receive a write scan signal GW through the write scan line GWLi, a first electrode connected to the data line DLj, and a second electrode connected to the first node N1. The second transistor T2 may supply a data signal DATA to the first node N1 in response to the write scan signal GW transmitted through the write scan line GWLi.

The capacitor C1 may include an electrode connected to the first node N1 and an electrode connected to the third node N3. The capacitor C1 may store the data signal DATA transmitted to the first node N1.

The light-emitting element LD may include an anode and a cathode. According to an embodiment, the anode of the light-emitting element LD is connected to the first power line VDL, and the cathode is connected to the pixel driver PDC-1 through the second node N2. According to an embodiment, the cathode of the light-emitting element LD may be connected to the first transistor T1. The light-emitting element LD may emit light in response to the amount of current flowing through the first transistor T1 of the pixel driver PDC-1.

According to an embodiment in which the first and second transistors T1 and T2 may be N-type transistors, the second node N2 to which the cathode of the light-emitting element LD and the pixel driver PDC-1 are connected may correspond to the drain of the first transistor T1. That is, it is possible to prevent a change in the gate-source voltage Vgs of the first transistor T1 by the light-emitting element LD. Accordingly, in a case that the amount of change in driving current due to degradation of the light-emitting element LD may be reduced, the afterimage defects of the display panel due to increased usage time may be reduced and the lifespan of the display panel may be improved.

Alternatively, as illustrated in FIG. 2C, the pixel PXij-2 may include a pixel driver PDC-2 including six transistors T1, T2, T3, T4a, T5a, and T6a and two capacitors C1 and C2.

The pixel driver PDC-2 may be connected to a light-emitting element LD, a write scan line GWLi, a reset scan line GRLi, a compensation scan line GCLi, an i-th first light-emitting line ESL1i (hereinafter referred to as a first light-emitting line), an i-th second light-emitting line ESL2i (hereinafter referred to as a second light-emitting line), a data line DLj, a first power line VDL, a second power line VSL, a third power line VRL, and an initialization voltage line VIL.

The structure of the pixel driver PDC-2 illustrated in FIG. 2C may be similar to that of the pixel driver PDC illustrated in FIG. 2A, from which the fourth transistor T4 and the fifth transistor T5 are omitted. In a case that the area of the pixel driver PDC-2 illustrated in FIG. 2C is smaller than that of the pixel driver PDC illustrated in FIG. 2A, the implementation of high resolution may be easier.

Each of the first to sixth transistors T1, T2, T3, T4a, T5a, and T6a may be an N-type transistor or a P-type transistor. According to an embodiment, each of the first to sixth transistors T1, T2, T3, T4a, T5a, and T6a is exemplarily described as an N-type transistor.

The first transistor T1 may include a gate connected to a first node N1, a first electrode connected to a second node N2, and a second electrode connected to a third node N3. The second node N2 may be connected to the first power line VDL side, and the third node N3 may be connected to the second power line VSL side. The first transistor T1 is connected to the light-emitting element LD through the second node N2 and the second power line VSL through the third node N3. The first transistor T1 may be a driving transistor.

The second transistor T2 may include a gate configured to receive a write scan signal GW through the write scan line GWLi, a first electrode connected to the data line DLj, and a second electrode connected to the first node N1. The second transistor T2 may supply a data signal DATA to the first node N1 in response to the write scan signal GW transmitted through the write scan line GWLi.

The third transistor T3 may be connected between the first node N1 and the reference voltage line VRL. The first electrode of the third transistor T3 may receive a reference voltage VREF through the reference voltage line VRL, and the second electrode of the third transistor T3 may be connected to the first node N1. According to an embodiment, the gate of the third transistor T3 may receive a reset scan signal GR through the reset scan line GRLi. When the reset scan signal GR is supplied to the reset scan line GRLi, the third transistor T3 may be turned on and provide the reference voltage VREF to the first node N1.

The fourth transistor T4a may be connected between the first transistor T1 and the light-emitting element LD. Specifically, the gate of the fourth transistor T4a may receive a first light-emitting signal EM1 through the first light-emitting line ESL1i. The first electrode of the fourth transistor T4a may be connected to the cathode of the light-emitting element LD through the fourth node N4, and the second electrode of the fourth transistor T4a may be connected to the first electrode of the first transistor T1 through the second node N2. The fourth transistor T4a may be referred to as a first light-emitting control transistor. When the first light-emitting signal EM1 is supplied to the first light-emitting line ESL1i, the fourth transistor T4a may be turned on and electrically connect the light-emitting element LD and the first transistor T1 to each other.

The fifth transistor T5a may be connected between the second power line VSL and the third node N3. The first electrode of the fifth transistor T5a may be connected to the second electrode of the first transistor T1 through the third node N3, and the second electrode of the fifth transistor T5a may receive the second power voltage VSS through the second power line VSL. The gate of the fifth transistor T5a may be electrically connected to the second light-emitting line ESL2i. The fifth transistor T5a may be referred to as a second light-emitting control transistor. When a second light-emitting signal EM2 is supplied to the second light-emitting line ESL2i, the fifth transistor T5a is turned on and electrically connects the second electrode of the first transistor T1 and the second power line VSL to each other.

Meanwhile, according to an embodiment, the fourth transistor T4a and the fifth transistor T5a may be connected to the first and second light-emitting lines ESL1i and ESL2i distinguished from each other and may be turned on through the first and second light-emitting signals EM1 and EM2 distinguished from each other. That is, the fourth transistor T4a and the fifth transistor T5a may be turned on independently of each other. However, this is only an example and embodiments of the inventive concept are not limited thereto. For example, in an embodiment of the inventive concept, the fourth transistor T4a and the fifth transistor T5a may be connected to a same light-emitting line and controlled by a same light-emitting signal. In addition, in the pixel driver PDC-2 according to an embodiment of the inventive concept, the fourth transistor T4a or the fifth transistor T5a may be omitted.

The sixth transistor T6a may be connected between the initialization voltage line VIL and the fourth node N4. That is, the sixth transistor T6a may include a gate connected to the compensation scan line GCLi, a first electrode connected to the initialization voltage line VIL, and a second electrode connected to the fourth node N4. The sixth transistor T6a may be referred to as an initialization transistor. The sixth transistor T6a may supply an initialization voltage VINT to the fourth node N4 corresponding to the cathode of the light-emitting element LD in response to the compensation scan signal GC transmitted through the compensation scan line GCLi. The cathode of the light-emitting element LD may be initialized by the initialization voltage VINT.

The first capacitor C1 may be disposed between the first node N1 and the third node N3. The first capacitor C1 may store a difference voltage between the first node N1 and the third node N3. The first capacitor C1 may be referred to as a storage capacitor.

The second capacitor C2 may be disposed between the third node N3 and the second power line VSL. That is, an electrode of the second capacitor C2 may be connected to the second power line VSL that receives the second power voltage VSS, and the other electrode of the second capacitor C2 may be connected to the third node N3. The second capacitor C2 may store a charge corresponding to a voltage difference between the second power voltage VSS and the third node N3. The second capacitor C2 may be referred to as a hold capacitor.

The light-emitting element LD may include an anode and a cathode. According to an embodiment, the anode of the light-emitting element LD is connected to the first power line VDL, and the cathode is connected to the pixel driver PDC-2 through the fourth node N4. According to an embodiment, the cathode of the light-emitting element LD may be connected to the first transistor T1 through the fourth transistor T4a. The light-emitting element LD may emit light in response to the amount of current flowing through the first transistor T1 of the pixel driver PDC-2.

According to an embodiment in which the first to sixth transistors T1, T2, T3, T4a, T5a, and T6a may be N-type transistors, the potential of the third node N3 corresponding to the source of the first transistor T1, which is a driving transistor, may not be directly affected by the characteristics of the light-emitting element LD. Accordingly, although degradation of the light-emitting element LD occurs, an effect on a gate-source voltage Vgs of the transistors constituting the pixel driver PDC-2, particularly the driving transistor, may be reduced. That is, in a case that the amount of change in driving current due to degradation of the light-emitting element LD may be reduced, the afterimage defects of the display panel due to increased usage time may be reduced and the lifespan of the display panel may be improved.

Meanwhile, FIGS. 2A, 2B, and 2C illustrate the circuits for the pixel drivers PDC, PDC-1, and PDC-2 according to an embodiment of the inventive concept, and in the display panel according to an embodiment of the inventive concept, as long as the circuits are connected to the cathode of the light-emitting element LD, the number or arrangement relationship of transistors and the number or arrangement relationship of capacitors may be designed in various ways and the inventive concept is not limited to any one embodiment.

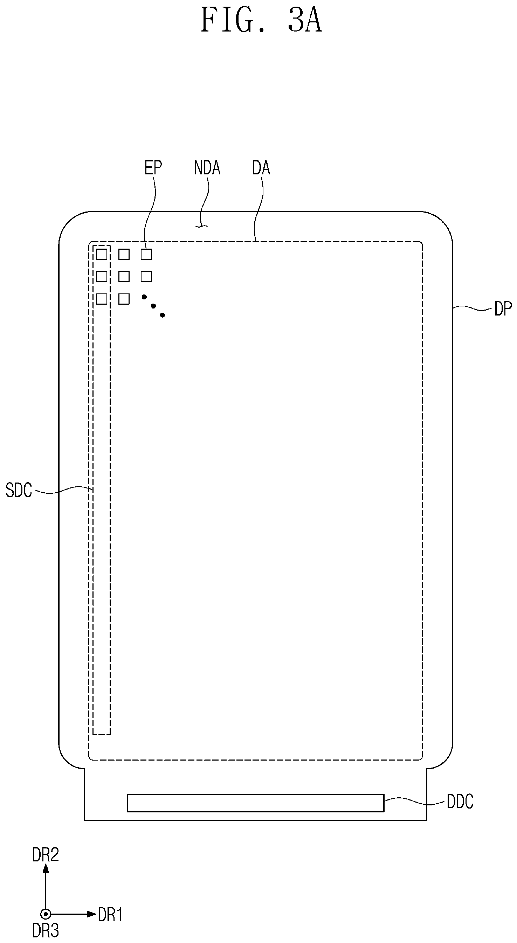

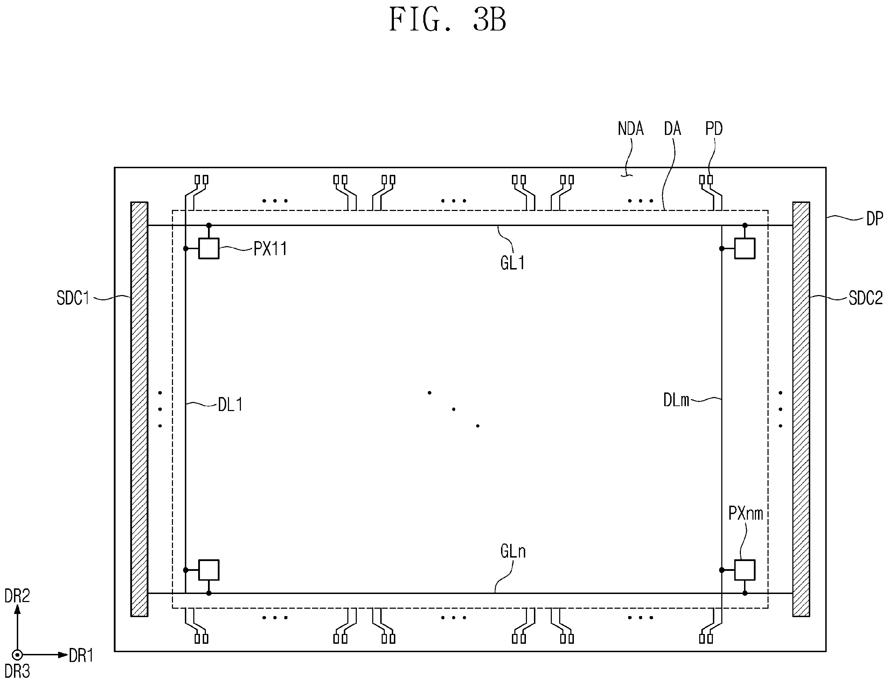

FIGS. 3A and 3B are plan views briefly illustrating a display panel according to an embodiment of the inventive concept. Each of FIGS. 3A and 3B are illustrated with some components omitted. Hereinafter, the inventive concept will be described with reference to FIGS. 3A and 3B.

Referring to FIG. 3A, the display panel DP according to an embodiment of the inventive concept may be divided into a display region DA and a peripheral region NDA (or non-display region). The display region DA may include a plurality of light-emitting portions EP.

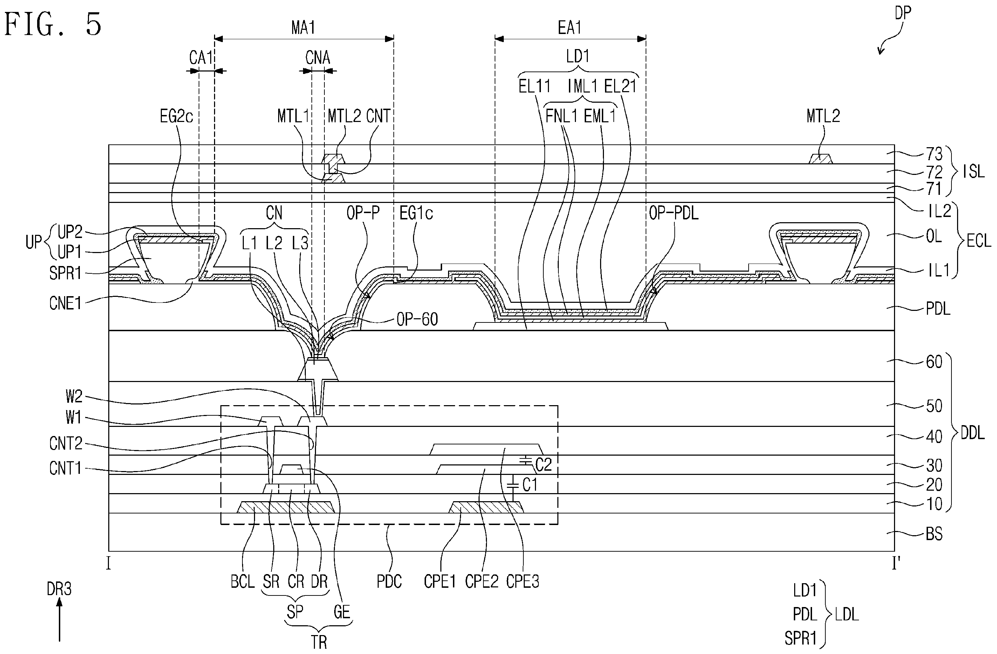

The light-emitting portions EP may be regions in which light is emitted by the pixels PXij (see FIG. 1), respectively. Specifically, each of the light-emitting portions EP may correspond to a light-emitting opening OP-PDL (see FIG. 5), described herein. The light-emitting opening OP-PDL may be referred to as an opening or an opening portion, for example, a first opening or a first opening portion.

The peripheral region NDA may be disposed to be adjacent to the display region DA. According to an embodiment, the peripheral region NDA is illustrated as a shape surrounding the edge of the display region DA. However, this is illustrated as an example, and the peripheral region NDA may be disposed on a side of the display region DA or may be omitted, and the inventive concept is not limited to any one embodiment.

According to an embodiment, a scan driver SDC and a data driver DDC may be mounted on the display panel DP. In an embodiment of the inventive concept, the scan driver SDC may be disposed in the display region DA, and the data driver DDC may be disposed in the peripheral region NDA. On a plane, the scan driver SDC may overlap at least some of the plurality of light-emitting portions EP disposed in the display region DA. As the scan driver SDC is disposed in the display region DA, the area of the peripheral region NDA may be reduced, compared to a typical display panel in which a scan driver is disposed in the peripheral region, and therefore, a display device having a narrow bezel may be easily implemented.

Meanwhile, the scan driver SDC may be provided as two divided portions. The two divided portions of the scan driver SDC may be disposed to be spaced apart from each other on both sides with the center of the display region DA interposed therebetween. Alternatively, the scan driver SDC may be provided as more than two portions, and the inventive concept is not limited to any one embodiment.

Meanwhile, FIG. 3A illustrates an example of a display panel, and the data driver DDC may be disposed in the display region DA. In this case, some of the light-emitting portions EP disposed in the display region DA may overlap the data driver DDC on a plane.

In an embodiment of the inventive concept, the data driver DDC may be provided in the form of a separate driving chip independent of the display panel DP and connected to the display panel DP. However, this is described as an example, and the data driver DDC may be formed in the same process as the scan driver SDC so as to constitute the display panel DP, and the inventive concept is not limited to any one embodiment.

As illustrated in FIG. 3B, the display panel DP may have a shape in which a length corresponding to the first direction DR1 is greater than a length corresponding to the second direction DR2. A plurality of pixels PX11 to PXnm arranged in n rows and m columns are exemplarily illustrated as being disposed in the display region DA. According to an embodiment, the display panel DP may include a plurality of scan drivers SDC1 and SDC2. The scan drivers SDC1 and SDC2 are exemplarily illustrated as including a first scan driver SDC1 and a second scan driver SDC2 spaced apart from each other in the first direction DR1.

The first scan driver SDC1 may be connected to some of the scan lines GL1 to GLn, and the second scan driver SDC2 may be connected to the other scan lines GL1 to GLn. For example, the first scan driver SDC1 may be connected to odd-numbered scan lines among the scan lines GL1 to GLn, and the second scan driver SDC2 may be connected to even-numbered scan lines among the scan lines GL1 to GLn.

For easy description, FIG. 3B illustrates pads PD of the data lines DL1 to DLm. The pads PD may be defined at ends of the data lines DL1 to DLm. The data lines DL1 to DLm may be connected to the data driver DDC (see FIG. 3A) through the pads PD.

According to this inventive concept, the pads PD may be divided and arranged at positions spaced apart from each other in the peripheral region NDA with the display region DA interposed therebetween. For example, some of the pads PD may be disposed on the upper side, that is, on the side adjacent to the first scan line GL1 among the scan lines GL1 to GLn, and the other pads PD may be disposed on the lower side, that is, on the side adjacent to the last scan line GLn among the scan lines GL1 to GLn. According to an embodiment, pads PD connected to odd-numbered data lines among the data lines DL1 to DLm may be disposed on the upper side, and pads PD connected to even-numbered data lines among the data lines DL1 to DLm. may be disposed on the lower side.

Although not illustrated, the display panel DP may include a plurality of upper data drivers connected to the pads PD disposed on the upper side and/or a plurality of lower data drivers connected to the pads PD disposed on the lower side. However, this is described as an example, and the display panel DP may include an upper data driver connected to the pads PD disposed on the upper side and/or a lower data driver connected to the pads PD disposed on the lower side. That is, the pads PD according to an embodiment of the inventive concept may be disposed on a side of the display panel DP and connected to a data driver. For example, the pads PD according to an embodiment of the inventive concept may be disposed on one side of the display panel DP and connected to a single data driver, however the inventive concept is not limited thereto.

In addition, as described in connection with FIG. 3A, in the display panel DP of FIG. 3B, the scan driver and/or the data driver may be disposed in the display region DA, and accordingly, some of the light-emitting portions disposed in the display region DA may overlap the scan driver and/or the data driver on a plane.

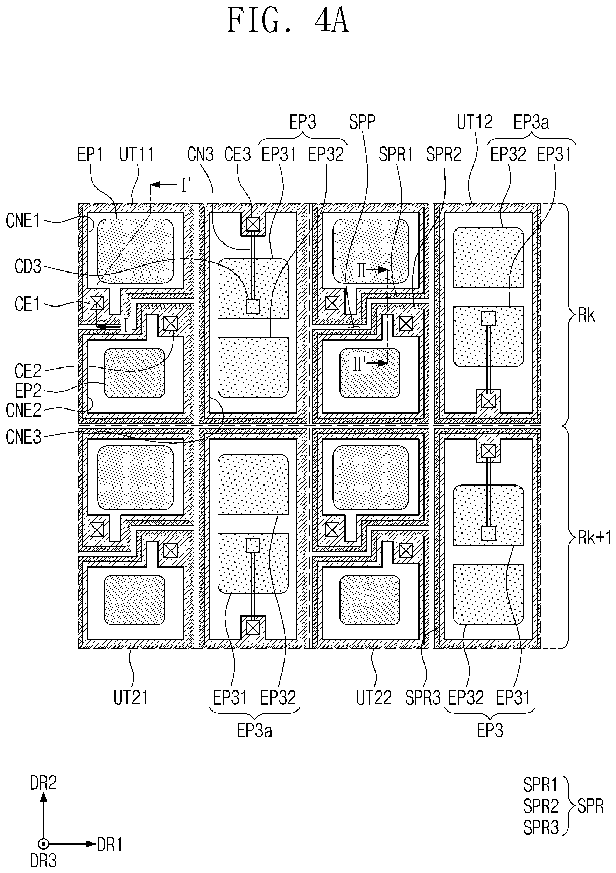

FIGS. 4A to 4D are enlarged plan views of a partial region of the display panel according to an embodiment of the inventive concept.

FIG. 4A illustrates light-emitting units UT11, UT12, UT21, and UT22 in two rows and two columns as an example. Referring to FIG. 4A, the light-emitting portions of a first row Rk include light-emitting portions constituting a first row, first column light-emitting unit UT11 and a first row, second column light-emitting unit UT12, and the light-emitting portions of a second row Rk+1 include light-emitting portions constituting a second row, first column light-emitting unit UT21 and a second row, second column light-emitting unit UT22.

Each of light-emitting portions EP1, EP2, and EP3 may correspond to a light-emitting opening OP-PDL (see FIG. 5) which will be described below. That is, each of the light-emitting portions EP1, EP2, and EP3 may be a region in which light is emitted by the light-emitting element described herein. The light-emitting portions EP1, EP2, and EP3 may correspond to a unit constituting an image displayed on the display panel DP (see FIG. 1). More specifically, each of the light-emitting portions EP1, EP2, and EP3 may correspond to a region defined by the light-emitting opening OP-PDL which will be described below, particularly, a region defined by the lower surface of the light-emitting opening OP-PDL.

The light-emitting portions EP1, EP2, and EP3 may include a first light-emitting portion EP1, a second light-emitting portion EP2, and a third light-emitting portion EP3. The first light-emitting portion EP1, the second light-emitting portion EP2, and the third light-emitting portion EP3 may emit light of different colors. For example, the first light-emitting portion EP1 may emit red light, the second light-emitting portion EP2 may emit green light, and the third light-emitting portion EP3 may emit blue light, but the combination of colors is not limited thereto. In addition, at least two of the light-emitting portions EP1, EP2, and EP3 may emit light of a same color. For example, all of the first to third light-emitting portions EP1, EP2, and EP3 may emit blue light or white light.

Among the first to third light-emitting portions EP1, EP2, and EP3, the third light-emitting portion EP3 that displays light emitted by the third light-emitting element may include two sub-light-emitting portions EP31 and EP32 spaced apart from each other in the second direction DR2. However, this is illustrated as an example, and the third light-emitting portion EP3 may be provided as a single pattern having an integrated shape like the first and second light-emitting portions EP1 and EP2, and one or more of the first or second light-emitting portions EP1 and EP2 may include sub-light-emitting portions spaced apart from each other, however the inventive concept is not limited thereto.

The light-emitting portions of the first row Rk may include first to third light-emitting portions EP1, EP2, and EP3 constituting the first row, first column light-emitting unit UT11 and first to third light-emitting portions EP1, EP2, and EP3a constituting the first row, second column light-emitting unit UT12, and the light-emitting portions of the second row Rk+1 may include first to third light-emitting portions EP1, EP2, and EP3a constituting the second row, first column light-emitting unit UT21 and first to third light-emitting portions EP1, EP2, and EP3 constituting the second row, second column light-emitting unit UT22.

In an embodiment of the inventive concept, the shapes of the light-emitting portions constituting the first row, first column light-emitting unit UT11 and the light-emitting portions constituting the second row, second column light-emitting unit UT22 may be substantially the same as each other. In addition, the shapes of the light-emitting portions constituting the first row, second column light-emitting unit UT12 and the shapes of the light-emitting portions constituting the second row, first column light-emitting unit UT21 may be substantially the same as each other. The shapes of the light-emitting portions constituting the first row, first column light-emitting unit UT11 may be different from the shapes of the light-emitting portions constituting the first row, second column light-emitting unit UT12. For example, some of the light-emitting portions of the first row Rk and some of the light-emitting portions of the second row Rk+1 may have shapes symmetrical to each other.

In an embodiment of the inventive concept, the third light-emitting portion EP3a of the second row, first column light-emitting unit UT21 and the third light-emitting portion EP3 of the first row, first column light-emitting unit UT11 may have a line-symmetrical shape and arrangement form with respect to an axis parallel to the first direction DR1, and the third light-emitting portion EP3 of the second row, second column light-emitting unit UT22 and the third light-emitting portion EP3a of the first row, second column light-emitting unit UT12 may have a line-symmetrical shape and arrangement form with respect to an axis parallel to the first direction DR1. However, this is an example and embodiments of the inventive concept are not limited thereto.

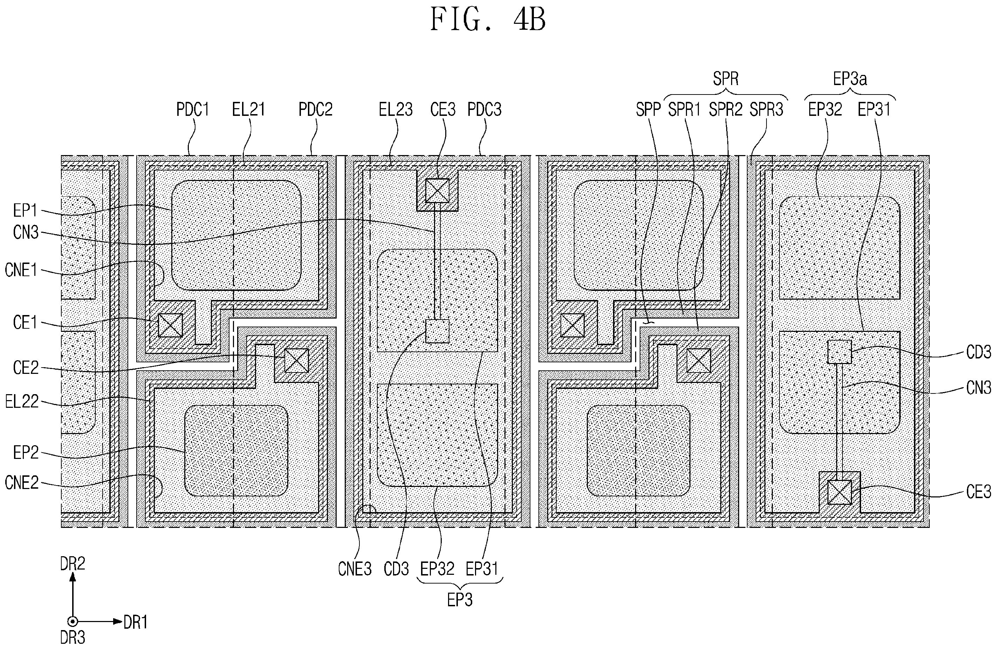

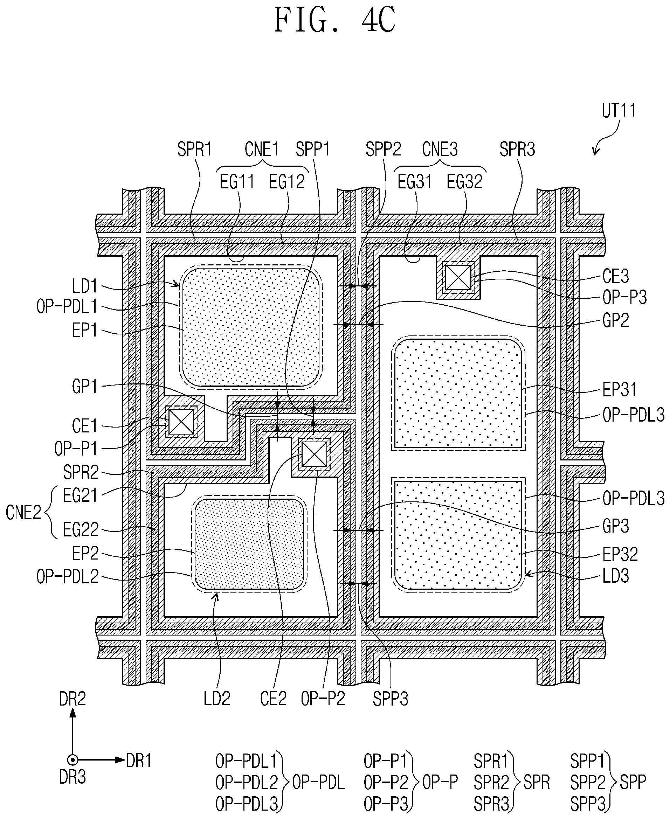

FIG. 4B illustrates light-emitting units arranged in a row. For easy explanation, FIG. 4B illustrates a plurality of upper electrodes EL21, EL22, and EL23, a plurality of pixel drivers PDC1, PDC2, and PDC3, first to third connection electrodes CNE1, CNE2, and CNE3, and a separator SPR. FIG. 4C illustrates, among the components of the display panel, a separator SPR, a plurality of light-emitting portions EP1, EP2, and EP3 disposed within a region divided by the separator SPR, and a plurality of connection electrodes CNE1, CNE2, and CNE3.

Referring to FIGS. 4A to 4C, the upper electrodes EL21, EL22, and EL23 may be electrically disconnected by being separated from each other by the separator SPR. According to an embodiment, a light-emitting unit UT11 may include three light-emitting portions EP1, EP2, and EP3. Accordingly, the light-emitting unit UT11 may include three upper electrodes EL21, EL22, and EL23 (hereinafter referred to as first to third cathodes), three pixel drivers PDC1, PDC2, and PDC3, and three connection electrodes CNE1, CNE2, and CNE3. However, this is illustrated as an example, and the number and arrangement of the light-emitting portions included in the light-emitting unit UT11 may be designed in various ways, and the inventive concept is not limited to any one embodiment.

The separator SPR includes a first separator SPR1 adjacent to the first light-emitting portion EP1 and a second separator SPR2 adjacent to the second light-emitting portion EP2. The separator SPR may further include a third separator SPR3 adjacent to the third light-emitting portion EP3. Each of the first separator SPR1, the second separator SPR2, and the third separator SPR3 may have a shape that surrounds at least a portion of each of the first light-emitting portion EP1, the second light-emitting portion EP2, and the third light-emitting portion EP3.

A spacer portion SPP is a space provided between two adjacent separators among the separators SPR. Spacer portions SPP may be respectively provided between the first separator SPR1 and the second separator SPR2, between the second separator SPR2 and the third separator SPR3, and between the third separator SPR3 and the first separator SPR1. A conductive material forming the plurality of connection electrodes CNE1, CNE2, and CNE3 may expose the spacer portion SPP.

As illustrated in FIG. 4C, a first sub-spacer portion SPP1 may be provided between the first separator SPR1 and the second separator SPR2, a second sub-spacer portion SPP2 may be provided between the third separator SPR3 and the first separator SPR1, and a third spacer portion SPP3 may be provided between the second separator SPR2 and the third separator SPR3.

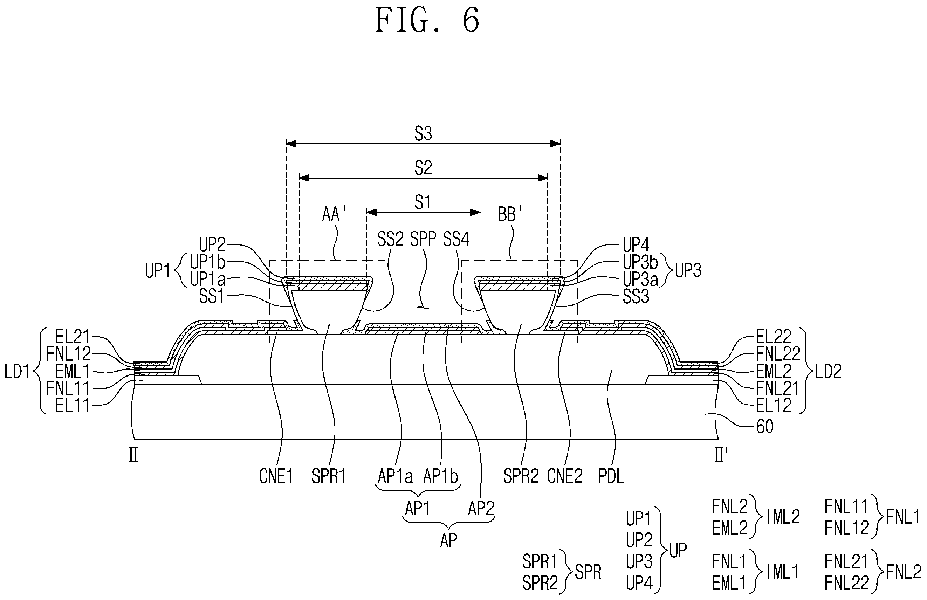

Through a spacer portion SPP provided between two adjacent separators in which a conductive material forming the plurality of connection electrodes CNE1, CNE2, and CNE3 may be omitted, a short may be prevented from occurring between adjacent light-emitting portions EP1, EP2, and EP3. The specific shapes of the separator SPR and the spacer portion SPP will be described in more detail later in the descriptions of FIG. 6, etc.

The first to third pixel drivers PDC1, PDC2, and PDC3 may be respectively electrically connected to first to third light-emitting elements LD1, LD2, and LD3 including the first to third light-emitting portions EP1, EP2, and EP3. In this specification, "being connected" may include a case of being physically connected by direct contact and a case of being electrically connected.

In addition, as illustrated in FIG. 4B, each region in which the first to third pixel drivers PDC1, PDC2, and PDC3 may be defined on a plane may correspond to a unit in which transistor and capacitor elements constituting the pixel driver PDC (see FIG. 2A) for driving the light-emitting element of a pixel are repeatedly arranged.

The first to third pixel drivers PDC1, PDC2, and PDC3 may be sequentially disposed along the first direction DR1. Meanwhile, the arrangement positions of the first to third pixel drivers PDC1, PDC2, and PDC3 may be designed independently, regardless of the positions or shapes of the first to third light-emitting portions EP1, EP2, and EP3.

For example, the first to third pixel drivers PDC1, PDC2, and PDC3 may be disposed in a position different from the region divided and defined by the separator SPR, that is, the position in which the first to third cathodes EL21, EL22, and EL23 are disposed, or may be designed to have a shape and area different from the shape and area of the first to third cathodes EL21, EL22, and EL23. Alternatively, the first to third pixel drivers PDC1, PDC2, and PDC3 may be disposed to respectively overlap positions, in which the first to third light-emitting portions EP1, EP2, and EP3 are present, and may be designed to have shapes and areas similar to the shapes and areas of the regions divided and defined by the separator SPR, for example, the first to third cathodes EL21, EL22, and EL23.

According to an embodiment, each of the first to third pixel drivers PDC1, PDC2, and PDC3 is illustrated as a rectangular shape, each of the first to third light-emitting portions EP1, EP2, and EP3 is arranged in a shape different from this and having a smaller area than this, and the first to third cathodes EL21, EL22, and EL23 are illustrated as atypical shapes in which they are disposed to overlap the first to third light-emitting portions EP1, EP2, and EP3.

Accordingly, as illustrated in FIG. 4B, the first pixel driver PDC1 may be disposed in a position overlapping the first light-emitting portion EP1, the second light-emitting portion EP2, and a portion of another adjacent light-emitting unit. The second pixel driver PDC2 may be disposed in a position overlapping the first light-emitting portion EP1, the second light-emitting portion EP2, and the third cathode EL23. The third pixel driver PDC3 may be disposed in a position overlapping the third light-emitting portion EP3. Meanwhile, this is illustrated as an example, and the positions of the first to third pixel drivers PDC1, PDC2, and PDC3 may be designed in various shapes and arrangements independently of the first to third light-emitting portions EP1, EP2, and EP3, and the inventive concept is not limited to any one embodiment.

The light-emitting unit UT11 may include first to third connection electrodes CNE1, CNE2, and CNE3. The first connection electrode CNE1 may electrically connect the first pixel driver PDC1 and the first light-emitting element LD1 forming the first light-emitting portion EP1 (or having the first light-emitting portion EP1 defined therein) to each other, the second connection electrode CNE2 may electrically connect the second pixel driver PDC2 and the second light-emitting element LD2 forming the second light-emitting portion EP2, and the third connection electrode CNE3 may electrically connect the third pixel driver PDC3 and the third light-emitting element LD3 forming the third light-emitting portion EP3.

Specifically, the first to third connection electrodes CNE1, CNE2, and CNE3 may electrically connect the first to third cathodes EL21, EL22, and EL23 to the first to third pixel drivers PDC1, PDC2, and PDC3, respectively, in a one-to-one correspondence.

Each of the first to third connection electrodes CNE1, CNE2, and CNE3 may be disposed on a pixel defining film PDL (see FIG. 5) to be described later. The first to third connection electrodes CNE1, CNE2, and CNE3 may have a ring shape surrounding the corresponding first to third light-emitting portions EP1, EP2, and EP3. In an embodiment of the inventive concept, each of the first to third connection electrodes CNE1, CNE2, and CNE3 is exemplarily illustrated as having a closed-line ring shape, but embodiments of the inventive concept are not limited thereto. For example, at least some of the first to third connection electrodes CNE1, CNE2, and CNE3 may have a broken open ring shape.

In a case that the first to third connection electrodes CNE1, CNE2, and CNE3 have a ring shape, the degree of freedom of the positions at which the first to third connection electrodes CNE1, CNE2, and CNE3 and the first to third pixel drivers PDC1, PDC2, and PDC3 are connected to each other may be improved. For example, the first connection electrode CNE1 may be connected to the first pixel driver PDC1 through a first connection part CE1, the second connection electrode CNE2 may be connected to the second pixel driver PDC2 through a second connection part CE2, and the third connection electrode CNE3 may be connected to the third pixel driver PDC3 through a connection line CN3. That is, connection lines additionally connected to the first and second connection electrodes CNE1 and CNE2 may be omitted.

A connection line CN3 may electrically connect the third pixel driver PDC3 and the third light-emitting element LD3 constituting the third light-emitting portion EP3. Specifically, the connection line CN3 may correspond to a node (see the fourth node N4 of FIG. 2A, the second node N2 of FIG. 2B, or the fourth node N4 of FIG. 2C) through which the light-emitting element LD (see FIG. 2A) is connected to the pixel driver (PDC of FIG. 2A, PDC-1 of FIG. 2B, or PDC-2 of FIG. 2C).

The connection line CN3 may include a third connection part CE3 and a driving connection portion CD3. The third connection part CE3 may be provided on a first side of the connection line CN3, and the driving connection portion CD3 may be provided on a second side of the connection line CN3.

The driving connection portion CD3 may be a portion of the connection line CN3 which is connected to the pixel driver PDC3. According to an embodiment, the driving connection portion CD3 may be connected to an electrode of a transistor constituting the pixel driver PDC3. Specifically, the driving connection portion CD3 may be connected to the drain of the sixth transistor T6 illustrated in FIG. 2A, the drain of the first transistor T1 illustrated in FIG. 2B, or the drain of the fourth transistor T4a illustrated in FIG. 2C. Accordingly, the position of the driving connection portion CD3 may correspond to the position of a transistor physically connected to the connection line CN3 of the pixel driver. The third connection part CE3 may be a portion of the connection line CN3 which is connected to the third light-emitting element LD3. According to an embodiment, the third connection part CE3 may be connected to the third connection electrode CNE3.

The first connection electrode CNE1 may include a first edge EG11 surrounding at least a portion of the first light-emitting portion EP1 and a second edge EG12 surrounding the first edge EG11. The second connection electrode CNE2 may include a first edge EG21 surrounding at least a portion of the second light-emitting portion EP2 and a second edge EG22 surrounding the first edge EG21. The third connection electrode CNE3 may include a first edge EG31 surrounding at least a portion of the third light-emitting portion EP3 and a second edge EG32 surrounding the first edge EG31.

The first to third connection electrodes CNE1, CNE2, and CNE3 may be arranged to be spaced apart from each other. For example, gaps GP1, GP2, and GP3 between adjacent connection electrodes among the first to third connection electrodes CNE1, CNE2, and CNE3 may overlap the separator SPR. For example, the first edges EG11, EG21, and EG31 of the first to third connection electrodes CNE1, CNE2, and CNE3 may not be covered by the separator SPR, and the second edges EG12, EG22, and EG32 of the first to third connection electrodes CNE1, CNE2, and CNE3 may overlap the separator SPR. Alternatively, the second edges EG12, EG22, and EG32 of the first to third connection electrodes CNE1, CNE2, and CNE3 may be covered by the separator SPR. A conductive material forming the first to third connection electrodes CNE1, CNE2, and CNE3 may expose the gaps GP1, GP2, and GP3 between adjacent connection electrodes.

In an embodiment of the inventive concept, the first to third connection parts CE1, CE2, and CE3 may be disposed in a position in which they do not overlap the first to third light-emitting portions EP1, EP2, and EP3 on a plane. For example, a light-emitting opening OP-PDL (see FIG. 5) and through holes OP-P (see FIG. 5) spaced apart from the light-emitting opening OP-PDL may be defined in the pixel defining film PDL.

The through holes OP-P may include a first through hole OP-P1, a second through hole OP-P2, and a third through hole OP-P3. The first to third connection parts CE1, CE2, and CE3 may be arranged to respectively correspond to the first to third through holes OP-P1, OP-P2, and OP-P3. The light-emitting opening OP-PDL may include a first light-emitting opening OP-PDL1, a second light-emitting opening OP-PDL2, and a third light-emitting opening OP-PDL3. The first to third light-emitting portions EP1, EP2, and EP3 may be defined to respectively correspond to the first to third light-emitting openings OP-PDL1, OP-PDL2, and OP-PDL3. Accordingly, the first to third connection parts CE1, CE2, and CE3 may be disposed in positions spaced apart from the first to third light-emitting portions EP1, EP2, and EP3.

The first to third connection electrodes CNE1, CNE2, and CNE3 may be disposed on the pixel defining film PDL (see FIG. 5). When viewed on a plane, the first connection electrode CNE1 may surround the first light-emitting opening OP-PDL1, the second connection electrode CNE2 may surround the second light-emitting opening OP-PDL2, and the third connection electrode CNE3 may surround the third light-emitting openings OP-PDL3.

According to an embodiment of the inventive concept, the driving connection portion CD3 in a position in which the connection line CN3 is connected to a transistor TR (see FIG. 5) of the third pixel driver PDC3 may be defined in a position that does not overlap the third connection part CE3 on a plane, and the driving connection portion CD3 may be disposed in a position that overlaps the third light-emitting portion EP3.

The first to third cathodes EL21, EL22, and EL23 may be connected to the first to third connection electrodes CNE1, CNE2, and CNE3. For example, the lower surfaces of the first to third cathodes EL21, EL22, and EL23 may be respectively connected to (or in contact with) the upper surfaces of the first to third connection electrodes CNE1, CNE2, and CNE3. Accordingly, the contact reliability (or connection stability) of the first to third cathodes EL21, EL22, and EL23 and the first to third connection electrodes CNE1, CNE2, and CNE3 may be further improved.

In addition, connection regions in which the first to third cathodes EL21, EL22, and EL23 and the first to third connection electrodes CNE1, CNE2, and CNE3 are connected to each other may respectively surround at least portions of the first to third light-emitting openings OP-PDL1, OP-PDL2, and OP-PDL3. The first to third cathodes EL21, EL22, and EL23 and the first to third connection electrodes CNE1, CNE2, and CNE3 may be connected to each other in regions adjacent to the separators SPR, and the contact regions may be defined to be respectively adjacent to the separators SPR. That is, the first to third cathodes EL21, EL22, and EL23 and the first to third connection electrodes CNE1, CNE2, and CNE3 need not be connected to each other at specific points, but may be connected to each other over relatively wide regions, for example, over regions similar to the shapes of the first to third connection electrodes CNE1, CNE2, and CNE3. That is, as the area of the connection contact increases, the connection may be stably maintained.

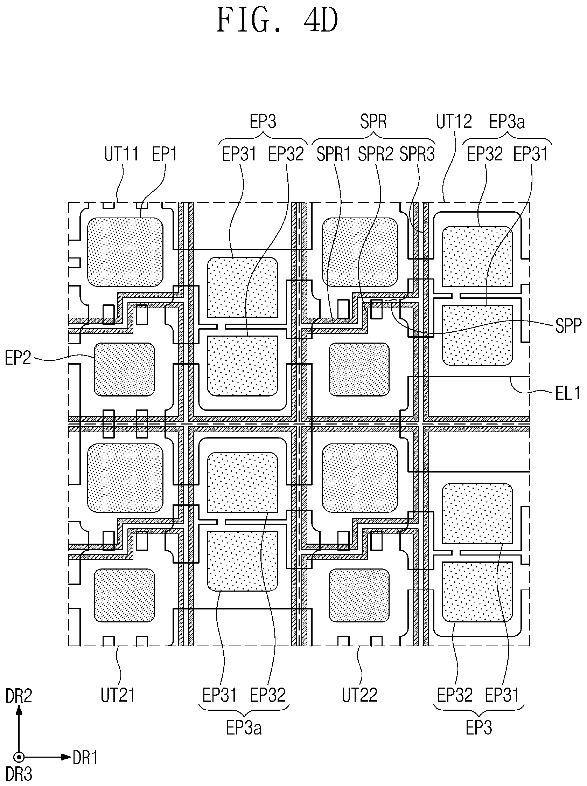

FIG. 4D illustrates a separator SPR, light-emitting portions EP1, EP2, and EP3, and a lower electrode EL1.

Referring to FIG. 4D, the lower electrode EL1 (hereinafter referred to as an anode) of the light-emitting element LD1 (see FIG. 5) according to an embodiment of the inventive concept may be provided in common to the first to third light-emitting portions EP1, EP2, and EP3. That is, the anode EL1 may be formed as an integrated layer in an entirety of the display region DA, and accordingly, the anode EL1 layer may be disposed to overlap the separator SPR. Alternatively, the anodes EL1 of the light-emitting elements LD1 may be formed as independent conductive patterns, which may be spaced apart from each other, and may be electrically connected to each other through other conductive layers, and accordingly, the anode EL1 patterns may be disposed to non-overlap the separator SPR.

As described herein, the first power voltage VDD (see FIG. 2A) may be applied to the anode EL1, and a common voltage may be provided to all light-emitting elements. The anode EL1 may be connected to the first power line VDL (see FIG. 2A) that provides the first power voltage VDD in the peripheral region NDA, or may be connected to the first power line VDL (see FIG. 2A) in the display region DA, and the inventive concept is not limited to any one embodiment.

Meanwhile, a plurality of openings may be defined in the anode EL1 according to an embodiment, and the openings may pass through the anode EL1 layer. The openings in the anode EL1 layer may be disposed in positions that do not overlap the light-emitting portions EP (see FIG. 3A) and may generally be defined in positions that overlap the separator SPR. The openings may facilitate the discharge of gas generated from an organic layer disposed below the anode EL1, for example, a sixth insulating layer 60 (see FIG. 5) described below. Accordingly, during a manufacturing process of the display panel, the gas from the organic layer disposed below the light-emitting element may be sufficiently discharged, and the gas discharged from the organic layer after manufacturing may be reduced, thereby decreasing the rate of the degradation of the light-emitting element.

FIG. 5 is a cross-sectional view of the display panel DP according to an embodiment of the inventive concept. FIG. 5 illustrates a cross-sectional view illustrating a portion that corresponds to line I-I' of FIG. 4A.

For the convenience of explanation, FIG. 5 exemplarily illustrates each configuration, arrangement, and connection relationship corresponding to the cross section of the region in which the first light-emitting element LD1 included in the first light-emitting portion EP1 of FIG. 4A is disposed, but similar descriptions may be applied to the cross section of the region in which the second light-emitting element LD2 included in the second light-emitting portion EP2 is disposed and the cross section of the region in which the third light-emitting element LD3 included in the third light-emitting portion EP3 is disposed. In addition, for the convenience of explanation, the first light-emitting element LD1 and the components included therein, which are illustrated in FIG. 5, are described as the components of the "light-emitting element LD1", and similar descriptions may be applied to the second light-emitting element LD2, the third light-emitting element LD3, and the components included therein.

Referring to FIG. 5, the display panel DP according to an embodiment of the inventive concept may include a base layer BS, a driving element layer DDL, a light-emitting element layer LDL, an encapsulation layer ECL, and a sensing layer ISL. However, this is only an example, and in an embodiment of the inventive concept, the display panel DP need not include the sensing layer ISL.

The driving element layer DDL may include a plurality of insulating layers 10, 20, 30, 40, 50, and 60 disposed on the base layer BS and a plurality of conductive patterns and semiconductor patterns disposed between the insulating layers 10, 20, 30, 40, 50, and 60. The conductive patterns and the semiconductor patterns may be disposed between the insulating layers 10, 20, 30, 40, 50, and 60 to form a pixel driver PDC.

The base layer BS may be a member configured to provide a base surface on which the pixel driver PDC is disposed. The base layer BS may be a rigid substrate or a flexible substrate capable of being bent, folded, or rolled. The base layer BS may be a glass substrate, a metal substrate, or a polymer substrate. However, embodiments of the inventive concept are not limited thereto, and the base layer BS may be an inorganic layer, an organic layer, or a composite material layer.

The base layer BS may have a multi-layer structure. The base layer BS may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. In addition, the polymer resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, or a perylene-based resin. Meanwhile, in this specification, a "~~"-based resin means to include a functional group of "~~".

Each of insulating layers, conductive layers, and semiconductor layers disposed on the base layer BS may be formed by coating, deposition, or the like. Hereafter, the insulating layer, the semiconductor layer, and the conductive layer may be selectively patterned through a plurality of photolithography processes to form a hole in the insulating layer, or a semiconductor pattern, a conductive pattern, a signal line, and the like may be formed.

The driving element layer DDL may include first to sixth insulating layers 10, 20, 30, 40, 50, and 60 sequentially stacked on the base layer BS and a pixel driver PDC. FIG. 5 illustrates a transistor TR and two capacitors C1 and C2 of the pixel driver PDC.

The transistor TR may correspond to a transistor connected to the light-emitting element LD1 through an intermediate connection electrode CN and the connection electrode CNE1, that is, a connection transistor connected to a node (the fourth node N4 of FIG. 2A, the second node N2 of FIG. 2B, or the fourth node N4 of FIG. 2C) corresponding to the cathode of the light-emitting element LD1, and specifically, the transistor TR may correspond to the sixth transistor T6 of FIG. 2A, the first transistor T1 of FIG. 2B, or the fourth transistor T4a of FIG. 2C. Meanwhile, although not illustrated, other transistors constituting the pixel driver PDC may have the same structure as the transistor TR (hereinafter referred to as a connection transistor) illustrated in FIG. 5. However, this is described as an example, and other transistors constituting the pixel driver PDC may have a structure different from that of the connection transistor TR, and the inventive concept is not limited to any one embodiment.

The first insulating layer 10 may be disposed on the base layer BS. The first insulating layer 10 may be an inorganic layer and/or an organic layer and have a single-layer or multi-layer structure. The first insulating layer 10 may include at least one of aluminum oxide, titanium oxide, silicon oxide, silicon nitride, silicon oxynitride, zirconium oxide, or hafnium oxide. According to an embodiment, the first insulating layer 10 is illustrated as a single-layer silicon oxide layer. Meanwhile, insulating layers to be described later may be inorganic layers and/or organic layers and have a single-layer or multi-layer structure. An inorganic layer may include at least one of the materials described herein, but embodiments of the inventive concept are not limited thereto.

Meanwhile, the first insulating layer 10 may cover a lower conductive layer BCL. That is, the display panel DP may further include the lower conductive layer BCL disposed to overlap the connection transistor TR. The lower conductive layer BCL may block an electric potential due to a polarization phenomenon of the base layer BS from affecting the connection transistor TR. In addition, the lower conductive layer BCL may block light incident from the lower side to the connection transistor TR. At least one of an inorganic barrier layer or a buffer layer may be further disposed between the lower conductive layer BCL and the base layer BS.

The lower conductive layer BCL may include a reflective metal. For example, the lower conductive layer BCL may include titanium (Ti), molybdenum (Mo), an alloy containing molybdenum, aluminum (Al), an alloy containing aluminum, aluminum nitride (AlN), tungsten (W), tungsten nitride (WN), copper (Cu), and the like.

According to an embodiment, the lower conductive layer BCL may be connected to the source of the transistor TR through a source electrode pattern W1. In this case, the lower conductive layer BCL may be synchronized with the source of the transistor TR. However, this is illustrated as an example, and the lower conductive layer BCL may be connected to and synchronized with the gate of the transistor TR. Alternatively, the lower conductive layer BCL may be connected to another electrode to independently receive a constant voltage or a pulse signal. Alternatively, the lower conductive layer BCL may be provided in an isolated form from other conductive patterns. The lower conductive layer BCL according to an embodiment of the inventive concept may be provided in various forms and is not limited to any one embodiment.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. For example, the oxide semiconductor may include transparent conductive oxide (TCO) such as indium tin oxide (ITO), indium zinc oxide (IZO), indium gallium zinc oxide (IGZO), zinc oxide (ZnO) or indium oxide (In₂O₃). Without being limited thereto, however, the semiconductor pattern SP may include amorphous silicon, low-temperature polycrystalline silicon, or polycrystalline silicon.

The semiconductor pattern SP may include a source region SR, a drain region DR, and a channel region CR, which may be divided according to the degree of conductivity. The channel region CR may overlap the gate electrode GE on a plane. The source region SR and the drain region DR may be spaced apart from each other with the channel region CR interposed therebetween. When the semiconductor pattern SP is an oxide semiconductor, each of the source region SR and the drain region DR may be a reduced region. Accordingly, the source region SR and the drain region DR have a reduced metal content which is relatively higher than that of the channel region CR. Alternatively, when the semiconductor pattern SP is made of polycrystalline silicon, each of the source region SR and the drain region DR may be a region doped at a high concentration.

The source region SR and the drain region DR may have relatively higher conductivity than the channel region CR. The source region SR may correspond to the source electrode of the connection transistor TR, and the drain region DR may correspond to the drain electrode of the connection transistor TR. As illustrated in FIG. 5, a separate source electrode pattern W1 and a separate drain electrode pattern W2 respectively connected to the source region SR and the drain region DR may be further provided. Specifically, each of the separate source electrode pattern W1 and the separate drain electrode pattern W2 may be integrally formed with a line of the lines constituting the pixel driver PDC (see FIG. 2A), PDC-1 (see FIG. 2B), or PDC-2 (see FIG. 2C), and the inventive concept is not limited to any one embodiment.

The second insulating layer 20 may overlap a plurality of pixels in common and cover the semiconductor pattern SP. The second insulating layer 20 may be an inorganic layer and/or an organic layer and have a single-layer or multi-layer structure. The second insulating layer 20 may include at least one of aluminum oxide, titanium oxide, silicon oxide, silicon nitride, silicon oxynitride, zirconium oxide, or hafnium oxide. According to an embodiment, the second insulating layer 20 may be a single-layer silicon oxide layer.

The gate electrode GE may be disposed on the second insulating layer 20. The gate electrode GE may correspond to the gate of the connection transistor TR. In addition, the gate electrode GE may be disposed above the semiconductor pattern SP. However, this is illustrated as an example, and the gate electrode GE may be disposed below the semiconductor pattern SP, and the inventive concept is not limited to any one embodiment.

The gate electrode GE may include titanium (Ti), silver (Ag), molybdenum (Mo), aluminum (Al), aluminum nitride (AlN), tungsten (W), tungsten nitride (WN), copper (Cu), or alloys thereof, but is not particularly limited thereto.

The third insulating layer 30 may be disposed on the gate electrode GE. The third insulating layer 30 may be an inorganic layer and/or an organic layer and have a single-layer or multi-layer structure. The fourth insulating layer 40 may include at least one of aluminum oxide, titanium oxide, silicon oxide, silicon nitride, silicon oxynitride, zirconium oxide, or hafnium oxide.

Among a plurality of conductive patterns W1, W2, CPE1, CPE2, and CPE3, a first capacitor electrode CPE1 and a second capacitor electrode CPE2 constitute the first capacitor C1. The first capacitor electrode CPE1 and the second capacitor electrode CPE2 may be spaced apart from each other with the first insulating layer 10 and the second insulating layer 20 interposed therebetween.

In an embodiment of the inventive concept, the first capacitor electrode CPE1 and the lower conductive layer BCL may have an integrated shape. In addition, the second capacitor electrode CPE2 and the gate electrode GE may have an integrated shape.

A third capacitor electrode CPE3 may be disposed on the third insulating layer 30. The third capacitor electrode CPE3 may be spaced apart from the second capacitor electrode CPE2 with the third insulating layer 30 interposed therebetween and overlap the second capacitor electrode CPE2 on a plane. The third capacitor electrode CPE3 and the second capacitor electrode CPE2 may constitute the second capacitor C2.

The fourth insulating layer 40 may be disposed on the third insulating layer 30 and/or the third capacitor electrode CPE3. The fourth insulating layer 40 may be an inorganic layer and/or an organic layer and have a single-layer or multi-layer structure. The fourth insulating layer 40 may include at least one of aluminum oxide, titanium oxide, silicon oxide, silicon nitride, silicon oxynitride, zirconium oxide, or hafnium oxide.

The source electrode pattern W1 and the drain electrode pattern W2 may be disposed on the fourth insulating layer 40. The source electrode pattern W1 may be connected to the source region SR of the connection transistor TR through a first contact hole CNT1, and the source electrode pattern W1 and the source region SR of the semiconductor pattern SP may function as the source of the connection transistor TR. The drain electrode pattern W2 may be connected to the drain region DR of the connection transistor TR through a second contact hole CNT2, and the drain electrode pattern W2 and the drain region DR of the semiconductor pattern SP may function as the drain of the connection transistor TR. The fifth insulating layer 50 may be disposed on the source electrode pattern W1 and the drain electrode pattern W2.

The intermediate connection electrode CN may be disposed on the fifth insulating layer 50. The intermediate connection electrode CN may electrically connect the pixel driver PDC and the light-emitting element LD1 to each other. That is, the intermediate connection electrode CN may electrically connect the connection transistor TR and the light-emitting element to each other. The intermediate connection electrode CN may be a connection node connecting the pixel driver PDC and the light-emitting element LD1 to each other. That is, the intermediate connection electrode CN may correspond to the fourth node N4 (see FIG. 2A) illustrated in FIG. 2A, the second node N2 (see FIG. 2B) illustrated in FIG. 2B, or the fourth node N4 (see FIG. 2C) illustrated in FIG. 2C.

The sixth insulating layer 60 may be disposed on the intermediate connection electrode CN. The sixth insulating layer 60 may be disposed on the fifth insulating layer 50 to cover the intermediate connection electrode CN. Each of the fifth insulating layer 50 and the sixth insulating layer 60 may be an organic layer. For example, each of the fifth insulating layer 50 and the sixth insulating layer 60 may include a general-purpose polymer such as benzocyclobutene (BCB), polyimide, hexamethyldisiloxane (HMDSO), polymethylmethacrylate (PMMA), or polystyrene (PS), a polymer derivative having a phenol-based group, an acrylic-based polymer, an imide-based polymer, an aryl ether-based polymer, an amide-based polymer, a fluorine-based polymer, a p-xylene-based polymer, a vinyl alcohol-based polymer, and blends thereof.

A through hole OP-60 exposing at least a portion of the intermediate connection electrode CN may be provided in the sixth insulating layer 60. The intermediate connection electrode CN may be connected to the connection electrode CNE1 through the portion exposed from the sixth insulating layer 60 and may be electrically connected to the light-emitting element LD1. That is, the intermediate connection electrode CN may electrically connect the connection transistor TR and the light-emitting element LD1 together with the connection electrode CNE1. In this specification, a region in which the intermediate connection electrode CN and the connection electrode CNE1 are connected to each other may be referred to as a connection region CNA. The connection region CNA may be defined by the through hole OP-60. Meanwhile, in the display panel DP according to an embodiment of the inventive concept, the sixth insulating layer 60 may be omitted or provided in plurality, and the inventive concept is not limited to any one embodiment. When the sixth insulating layer 60 is omitted, the intermediate connection electrode CN may also be omitted.

The intermediate connection electrode CN may include a first layer L1, a second layer L2, and a third layer L3 sequentially stacked along a third direction DR3. The second layer L2 may include a material different from that of the first layer L1. In addition, the second layer L2 may include a material different from that of the third layer L3. The second layer L2 may have a relatively greater thickness than the first layer L1. In addition, the second layer L2 may have a relatively greater thickness than the third layer L3. The second layer L2 may include a highly conductive material. In an embodiment of the inventive concept, the second layer L2 may include aluminum (Al).

The light-emitting element layer LDL may be disposed on the driving element layer DDL. The light-emitting element layer LDL may include a pixel defining film PDL, a light-emitting element LD1, and a separator SPR.

The pixel defining film PDL may be an organic layer. For example, the pixel defining film PDL may include a general-purpose polymer such as benzocyclobutene (BCB), polyimide, hexamethyldisiloxane (HMDSO), polymethylmethacrylate (PMMA), or polystyrene (PS), a polymer derivative having a phenol-based group, an acrylic-based polymer, an imide-based polymer, an aryl ether-based polymer, an amide-based polymer, a fluorine-based polymer, a p-xylene-based polymer, a vinyl alcohol-based polymer, and blends thereof.

In an embodiment of the inventive concept, the pixel defining film PDL may have the property of absorbing light and have, for example, a black color. That is, the pixel defining film PDL may include a black coloring agent. The black coloring agent may include a black dye and a black pigment. The black coloring agent may include carbon black, a metal such as chromium, or an oxide thereof. The pixel defining film PDL may correspond to a light blocking pattern having the property of blocking light.

An opening OP-PDL (hereinafter referred to as a light-emitting opening) exposing at least a portion of a lower electrode EL1 1, which will be described later, may be defined in the pixel defining film PDL. The light-emitting opening OP-PDL may be provided in plurality and they may be disposed to respectively correspond to light-emitting elements. All the components of the light-emitting element LD1 may be disposed to overlap each other in the light-emitting opening OP-PDL, and the light-emitting opening OP-PDL may be a region in which light emitted by the light-emitting element LD is substantially displayed. Accordingly, the shape of the light-emitting portion EP1 (see FIG. 4A) may substantially correspond to the shape of the light-emitting opening OP-PDL on a plane. Meanwhile, a region corresponding to the light-emitting portion EP1, that is, the region defined by the light-emitting opening OP-PDL may be referred to as a light-emitting region EA1.

The connection electrode CNE1 may be disposed on the pixel defining film PDL. The connection electrode CNE1 may electrically connect the pixel driver PDC and the light-emitting element LD1. That is, the pixel driver PDC may be electrically connected to the light-emitting element LD1 via the intermediate connection electrode CN and the connection electrode CNE1. The connection electrode CNE1 illustrated in FIG. 5 may correspond to the first connection electrode CNE1 illustrated in FIG. 4A. The second connection electrode CNE2 (see FIG. 4A) and the third connection electrode CNE3 (see FIG. 4A) may also have a structure similar to that of the first connection electrode CNE1.

The connection electrode CNE1 may include a first edge EG1c adjacent to the light-emitting opening OP-PDL and a second edge EG2c surrounding the first edge EG1c. The upper electrode EL21 of the light-emitting element LD1 may be in contact with the connection electrode CNE1 in a region adjacent to the second edge EG2c.

The connection electrode CNE1 may include a transparent conductive oxide (TCO) such as indium tin oxide (ITO), indium zinc oxide (IZO), indium gallium zinc oxide (IGZO), zinc oxide (ZnO), or indium oxide (In₂O₃). However, the material constituting the connection electrode CNE1 is not limited to the examples described herein. For example, the connection electrode CNE1 may include a metal material. The material forming the connection electrode CNE1 may be disposed on a first side surface of the first separator SPR1 facing the light-emitting region EA1 and may expose a second side surface of the first separator SPR1 facing away from the light-emitting region EA1.

A through hole OP-P spaced apart from the light-emitting opening OP-PDL may be defined in the pixel defining film PDL. The through hole OP-P may be provided in plurality, and they may be disposed to respectively correspond to light-emitting elements. The size of the through hole OP-P defined in the pixel defining film PDL may be larger than the size of the through hole OP-60 defined in the sixth insulating layer 60. The connection electrode CNE1 may be disposed in the through hole OP-P and the through hole OP-60 and connected to the intermediate connection electrode CN.

The light-emitting element LD1 includes a lower electrode EL11, an intermediate layer IML1, and an upper electrode EL21.

The lower electrode EL11 may be a semi-transmissive, transmissive, or reflective electrode. According to an embodiment of the inventive concept, the lower electrode EL11 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or a compound thereof and a transparent or semi-transparent electrode layer formed on the reflective layer. The transparent or semi-transparent electrode layer may include at least one of indium tin oxide (ITO), indium zinc oxide (IZO), indium gallium zinc oxide (IGZO), zinc oxide (ZnO) or indium oxide (In₂O₃), or aluminum-doped zinc oxide (AZO). For example, the lower electrode EL11 may include a stacked structure of ITO/Ag/ITO.

According to an embodiment, the lower electrode EL11 may be the anode of the light-emitting element LD1. That is, the lower electrode EL11 may be connected to the first power line VDL (see FIG. 2A), and the first power voltage VDD (see FIG. 2A) may be applied. The lower electrode EL11 may be connected to the first power line VDL within the display region DA (see FIG. 3A or FIG. 3B), or may be connected to the first power line VDL in the peripheral region NDA. In the latter case, the first power line VDL may be disposed in the peripheral region NDA (see FIG. 3A or FIG. 3B), and the lower electrode EL11 may have a shape in which it extends to the peripheral region NDA.

In the cross-sectional view of FIG. 5, the lower electrode EL11 is illustrated as overlapping the light-emitting opening OP-PDL and non-overlapping the separator SPR1, but as described in connection with FIG. 4D, the lower electrodes EL11 of the light-emitting elements have an integrated shape and may have a mesh or lattice shape in which openings are defined in a partial region. That is, as long as a same first power voltage VDD can be applied to the lower electrode EL11 of each of the plurality of light-emitting elements, the shape of the lower electrode EL11 may be provided in various ways, and the inventive concept is not limited to any one embodiment.

The intermediate layer IML1 may be disposed between the lower electrode EL11 and the upper electrode EL21. The intermediate layer IML1 may include a light-emitting layer EML1 and a functional layer FNL1. The light-emitting element LD1 may include an intermediate layer IML1 having various structures, and the inventive concept is not limited to any one embodiment. For example, the functional layer FNL1 may be provided as a plurality of layers or as two or more layers spaced apart from each other with the light-emitting layer EML1 interposed therebetween.

The functional layer FNL1 may be disposed between the lower electrode EL11 and the upper electrode EL21. According to an embodiment, the light-emitting layer EML1 is illustrated as being inserted into the functional layer FNL1. That is, it can be understood that the light-emitting layer EML1 is disposed between a first intermediate functional layer FNL11 (see FIG. 6) and a second intermediate functional layer FNL12 (see FIG. 6) which will be described later.

The functional layer FNL1 may control the movement of charge between the lower electrode EL11 and the upper electrode EL21. For example, the functional layer FNL1 may include a hole injection/transport material and/or an electron injection/transport material. The functional layer FNL1 may include at least one of an electron blocking layer, a hole transport layer, a hole injection layer, a hole blocking layer, an electron transport layer, an electron injection layer, or a charge generation layer.

The light-emitting layer EML1 may include an organic light-emitting material. In addition, the light-emitting layer EML1 may include an inorganic light-emitting material, or may be provided as a mixed layer of an organic light-emitting material and an inorganic light-emitting material. According to an embodiment, the light-emitting layer EML1 included in each adjacent light-emitting portion EP (see FIG. 3A) may include a light-emitting material that displays a different color. For example, the light-emitting layer EML1 included in each light-emitting portion EP may provide any one of blue light, red light, or green light. Without being limited thereto, however, the light-emitting layers EML1 disposed in all of the light-emitting portions EP may include a light-emitting material that displays a same color. In this case, the light-emitting layer EML1 may provide blue light or white light.

The upper electrode EL21 may be disposed on the intermediate layer IML1. As described herein, the upper electrode EL21 may be connected to the connection electrode CNE1 and electrically connected to the pixel driver PDC. That is, the upper electrode EL21 may be electrically connected to the connection transistor TR through the connection electrode CNE1.

The separator SPR1 may be disposed on the pixel defining film PDL. The separator SPR1 may be disposed on the gap GP1 to GP3 (see FIG. 4C) between the connection electrode CNE1 disposed on the pixel defining film PDL and an adjacent first connection electrode adjacent to the connection electrode CNE1.

The upper electrode EL21 and the functional layer FNL1 may be formed by common deposition on a plurality of pixels through an open mask. In this case, the upper electrode EL21 and the functional layer FNL1 may be divided by the separator SPR1. As described herein, the separator SPR1 may have a closed-line shape corresponding to and surrounding each of the light-emitting portions, and accordingly, the upper electrode EL21 and the functional layer FNL1 may have a divided shape for each of the light-emitting portions. That is, the upper electrode EL21 and the intermediate layer IML may be electrically independent of each other for each adjacent pixel.

In an embodiment of the inventive concept, the separator SPR1 may have a reverse taper shape. That is, the separator SPR1 may have a shape having a width that increases with a height away from the upper surface of the pixel defining film PDL. Side surfaces SS1 and SS2 (see FIG. 6) of the separator SPR1 may have an obtuse taper angle inclined from the upper surface of the pixel defining film PDL. However, this is illustrated as an example, and as long as the separator SPR1 can electrically disconnect the upper electrode EL21 for each pixel, the taper angle of the separator SPR1 may be set in various ways, and for example, the separator SPR1 may have a double structure having a different taper angle. In addition, the separator SPR1 may have a tip-portion-like structure, and the inventive concept is not limited to any one embodiment. For example, as illustrated in FIG. 5, the separator SPR1 may have a double reverse taper shape.

The separator SPR1 may include an insulating material, and in particular, may include an organic insulating material. The separator SPR1 may include an inorganic insulating material, may be composed of multiple layers having an organic insulating material and an inorganic insulating material, and may include a conductive material according to an embodiment of the inventive concept. That is, as long as the upper electrode EL21 can be electrically disconnected for each pixel, the type of material of the separator SPR1 is not particularly limited.

A dummy layer UP may be disposed on the separator SPR1. The dummy layer UP may include a first dummy layer UP1 disposed on the separator SPR1 and a second dummy layer UP2 disposed on the first dummy layer UP1. The first dummy layer UP1 may be formed through the same process as and with the inclusion of the same material as the intermediate layer IML1. The second dummy layer UP2 may be formed through the same process as and with the inclusion of the same material as the upper electrode EL21. That is, the first dummy layer UP1 and the second dummy layer UP2 may be formed simultaneously in a process of forming the functional layer FNL1 and the upper electrode EL21.

The upper electrode EL21 is in contact with the connection electrode CNE1 through a contact region CA1. The contact region CA1 is provided to be adjacent to the separator SPR1. In the contact region CA1, the upper surface of the connection electrode CNE1 may be in contact with the lower surface of the upper electrode EL21. Meanwhile, in a case that the separator SPR1 has a reverse taper shape and the contact region CA1 is provided to be adjacent to the separator SPR1, at least a portion of the contact region CA1 in which the upper electrode EL21 and the connection electrode CNE1 are in contact with each other may be disposed below the side surface of the separator SPR1.

The display panel DP according to an embodiment of the inventive concept may include an intermediate region MA1 disposed between the contact region CA1 and the light-emitting region EA1 in which the light-emitting element LD1 is disposed. The intermediate region MA1 may be adjacent to the contact region CA1. The intermediate region MA1 may be a region in which at least a portion of the intermediate layer IML1 is disposed. In the intermediate region MA1, the functional layer FNL1 included in the intermediate layer IML1 may be disposed between the connection electrode CNE1 and the upper electrode EL21. That is, in the intermediate region MA1, the connection electrode CNE1 and the upper electrode EL21 may be spaced apart from each other with the functional layer FNL1 interposed therebetween.

In the display panel DP according to an embodiment of the inventive concept, the functional layer FNL1 and the upper electrode EL21 may be formed by different deposition process methods. The upper electrode EL21 may be formed by a deposition method that can deposit a deposition material at a lower incident angle than a deposition method for forming the functional layer FNL1. The functional layer FNL1 may be formed by, for example, a thermal evaporation method, and the upper electrode EL21 may be covered by a sputtering method. Accordingly, in a process of forming the functional layer FNL1, a material forming the functional layer FNL1 may not enter the lower side of the separator SPR1, thereby exposing a portion of the connection electrode CNE1, and the upper electrode EL21 may be formed so as to be more adjacent to the separator SPR1 than the functional layer FNL1, so that the upper electrode EL21 may be in contact with the upper surface CNE-us of the exposed connection electrode CNE1. That is, in the process of forming the functional layer FNL1 and the upper electrode EL21, the contact region CA1 in which the upper electrode EL21 and the connection electrode CNE1 are in contact with each other may be formed through a difference in a deposition process method.

Meanwhile, as illustrated in FIG. 5, the connection region CNA in which the connection electrode CNE1 is connected to the intermediate connection electrode CN may be disposed between the light-emitting region EA1 and the contact region CA1. The connection region CNA may overlap the intermediate region MA1. At least a portion of the intermediate layer IML1 may be disposed to overlap the connection region CNA. In the display panel DP according to an embodiment of the inventive concept, the functional layer FNL1 included in the intermediate layer IML may be disposed to overlap the connection region CNA.

According to an embodiment of the inventive concept, the connection electrode CNE1 has a shape that surrounds at least a portion of the light-emitting region EA1 in which the light-emitting element LD1 is disposed. Accordingly, the degree of freedom of the position at which the connection electrode CNE1 and the light-emitting element LD1 are connected to each other and the degree of freedom of the position at which the connection electrode CNE1 and the pixel driver PDC are connected to each other may be improved. In addition, the upper surface of the connection electrode CNE1 and the lower surface of the upper electrode EL21 of the light-emitting element LD1 may be in contact with each other through the contact region CA1 defined to be adjacent to the separator SPR1. Accordingly, the contact reliability of the connection electrode CNE1 and the upper electrode EL21 may be improved, and in a case that the lower surface of the connection electrode CNE1 and the upper surface of the intermediate connection electrode CN are in contact with each other, the contact reliability may be improved. In the display panel DP according to an embodiment of the inventive concept, the sizes of the through holes OP-P and OP-60 for connecting the connection electrode CNE1 and the intermediate connection electrode CN to each other through the described structure may be reduced or minimized, and accordingly, the area or resolution of the light-emitting portion of the display panel DP may be easily increased.

In the display panel DP according to an embodiment of the inventive concept, the encapsulation layer ECL may be disposed on the light-emitting element layer LDL. The encapsulation layer ECL may cover the light-emitting element LD1 and the separator SPR1. The encapsulation layer ECL may include a first inorganic layer IL1, an organic layer OL, and a second inorganic layer IL2 that may be sequentially stacked. Without being limited thereto, however, the encapsulation layer ECL may additionally include a plurality of inorganic layers and organic layers. In addition, the encapsulation layer ECL may be a glass substrate.

The first and second inorganic layers IL1 and IL2 may protect the light-emitting element LD1 from moisture and oxygen outside the display panel DP, and the organic layer OL may protect the light-emitting element LD1 from foreign substances such as particles remaining in a process of forming the first inorganic layer IL1. The first and second inorganic layers IL1 and IL2 may include a silicon nitride layer, a silicon oxynitride layer, a silicon oxide layer, a titanium oxide layer, an aluminum oxide layer, or the like. The organic layer OL may include an acrylic-based organic layer, and the type of material is not limited to any one embodiment.

The sensing layer ISL may sense an external input. According to an embodiment, the sensing layer ISL may be formed on the encapsulation layer ECL through a continuous process. In this case, the sensing layer ISL may be expressed as being disposed directly on the encapsulation layer ECL. Being directly disposed may mean that no other components are disposed between the sensing layer ISL and the encapsulation layer ECL. That is, a separate adhesive member may not be disposed between the sensing layer ISL and the encapsulation layer ECL. However, this is illustrated as an example, and in the display panel DP according to an embodiment of the inventive concept, the sensing layer ISL may be separately formed and then coupled to the display panel DP by an adhesive member, and the inventive concept is not limited to any one embodiment.

The sensing layer ISL may include a plurality of conductive layers and a plurality of insulating layers. The plurality of conductive layers may include a first sensing conductive layer MTL1 and a second sensing conductive layer MTL2, and the plurality of insulating layers may include first to third sensing insulating layers 71, 72, and 73. However, this is illustrated as an example, and the number of the conductive layers and the number of the insulating layers are not limited to any one embodiment.

Each of the first to third sensing insulating layers 71, 72, and 73 may have a single-layer structure or a multi-layer structure in which layers may be stacked along the third direction DR3. The first to third sensing insulating layers 71, 72, and 73 may include an inorganic film. The inorganic film may include at least one of aluminum oxide, titanium oxide, silicon oxide, silicon nitride, silicon oxynitride, zirconium oxide, or hafnium oxide. The first to third sensing insulating layers 71, 72, and 73 may include an organic film. The organic film may include one or more of an acrylic-based resin, a methacrylic-based resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be connected to the first sensing conductive layer MTL1 through a contact hole CNT formed in the second sensing insulating layer 72. Each of the first sensing conductive layer MTL1 and the second sensing conductive layer MTL2 may have a single-layer structure or a multi-layer structure in which layers are stacked along the third direction DR3.

A single-layer sensing conductive layer may include a metal layer or a transparent conductive layer. The metal layer may include molybdenum, silver, titanium, copper, aluminum, or alloys thereof. The transparent conductive layer may include a transparent conductive oxide such as indium tin oxide (ITO), indium zinc oxide (IZO), zinc oxide (ZnO), or indium zinc tin oxide (IZTO). Alternatively, the transparent conductive layer may include a conductive polymer such as PEDOT, metal nanowire, graphene, and the like.

A multi-layer sensing conductive layer may include metal layers. The metal layers may have, for example, a layered structure of titanium (Ti)/aluminum (Al)/titanium (Ti). Alternatively, the multi-layer sensing conductive layer may include at least one metal layer and at least one transparent conductive layer.

The first sensing conductive layer MTL1 and the second sensing conductive layer MTL2 may form a sensor that senses an external input in the sensing layer ISL. The sensor may be driven by a capacitive method and may be driven by either a mutual-capacitance method or a self-capacitance method. However, this is described as an example, and the sensor may be driven by a resistive method, an ultrasonic method, or an infrared method in addition to the capacitive method, and the inventive concept is not limited to any one embodiment.

Each of the first sensing conductive layer MTL1 and the second sensing conductive layer MTL2 may include a transparent conductive oxide and have a metal mesh shape formed of an opaque conductive material. As long as the visibility of an image displayed by the display panel DP is not reduced, the first sensing conductive layer MTL1 and the second sensing conductive layer MTL2 may include various materials and have various shapes, and the inventive concept is not limited to any one embodiment.

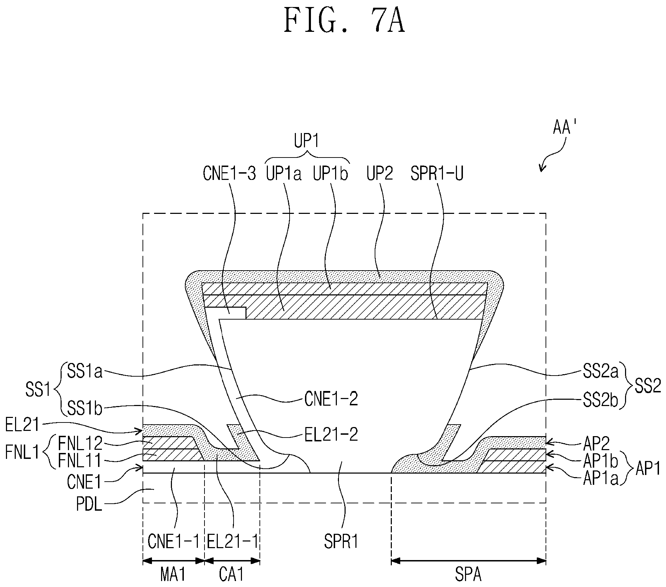

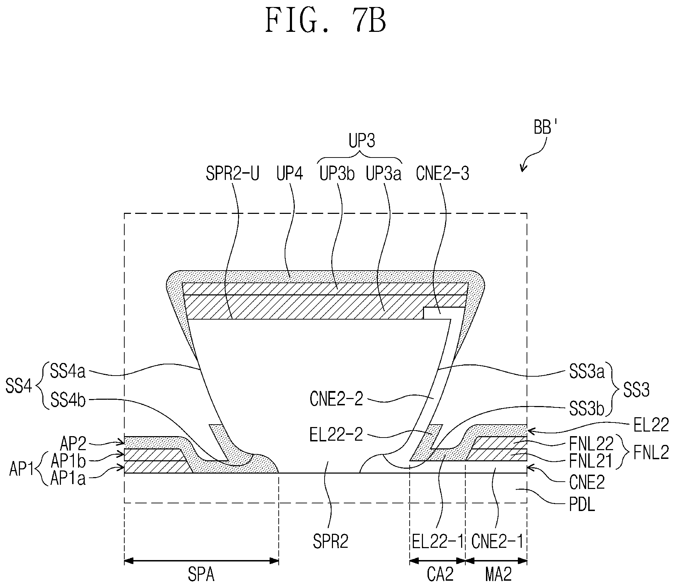

FIG. 6 is a cross-sectional view of the display panel DP according to an embodiment of the inventive concept. FIG. 6 illustrates a cross-sectional view illustrating a portion corresponding to line II-II' of FIG. 4A. Each of FIGS. 7A and 7B is an enlarged cross-sectional view of a portion of the display panel according to an embodiment of the inventive concept. FIG. 7A illustrates a cross section corresponding to region AA' of FIG. 6, and FIG. 7B illustrates a cross section corresponding to region BB' of FIG. 6. FIGS. 7A and 7B illustrate the shapes of the first separator SPR1 and the second separator SPR2 illustrated in FIG. 6 and contact regions CA1 and CA2 adjacent thereto.

FIG. 6 illustrates the arrangement structure of two light-emitting elements LD1 and LD2 disposed to be adjacent to each other and separators SPR disposed between them, and for the convenience of explanation, the base layer BS, some components of the driving element layer DDL, the encapsulation layer ECL, and the sensing layer ISL already described in FIG. 5 are omitted without illustration.

Referring to FIGS. 5 and 6 together, the display panel DP according to an embodiment of the inventive concept includes a first light-emitting element LD1 and a second light-emitting element LD2 which may be disposed to be adjacent to each other, and the upper electrodes EL21 and EL22 of the first light-emitting element LD1 and the second light-emitting element LD2 may be electrically disconnected from each other by being separated by the separators.

The separators SPR include a first separator SPR1 adjacent to the first light-emitting element LD1 and a second separator SPR2 adjacent to the second light-emitting element LD2. The first separator SPR1 and the second separator SPR2 may be spaced apart from each other along a direction. On a cross section, the first separator SPR1 and the second separator SPR2 may be disposed between the first light-emitting element LD1 and the second light-emitting element LD2. The separation direction of the first separator SPR1 and the second separator SPR2 may be parallel to the separation direction of the first light-emitting element LD1 and the second light-emitting element LD2. The second separator SPR2 may be disposed between the first separator SPR1 and the second light-emitting element LD2, and the first separator SPR1 may be disposed between the second separator SPR2 and the first light-emitting element LD1.

The connection electrodes CNE1 and CNE2 connecting the light-emitting elements LD1 and LD2 and the pixel driver PDC to each other are formed of a conductive material. For example, the connection electrodes CNE1 and CNE2 may be formed of a transparent conductive oxide (TCO). The conductive material forming the connection electrodes CNE1 and CNE2 may expose the spacer portion SPP. For example, the conductive material forming the connection electrodes CNE1 and CNE2 need not be disposed in the spacer portion SPP.

The connection electrodes CNE1 and CNE2 connecting the light-emitting elements LD1 and LD2 and the pixel driver PDC to each other need not be disposed in the spacer portion SPP. The connection electrodes CNE1 and CNE2 may be respectively disposed on portions of the upper portions of the first and second separators SPR1 and SPR2, but do not overlap the spacer portion SPP and portions of the upper portions of the first and second separators SPR1 and SPR2 which may be disposed in the spacer portion SPP. For example, the material forming the connection electrodes CNE1 and CNE2 need not be formed in the spacer portion SPP. The connection electrodes CNE1 and CNE2 may be respectively disposed on first portions of the upper portions of the first and second separators SPR1 and SPR2 and may respectively expose second portions of the upper portions of the first and second separators SPR1 and SPR2. For example, the material forming the connection electrodes CNE1 and CNE2 may expose the second portions of the upper portions of the first and second separators SPR1 and SPR2.

Each separator of the first and second separators SPR1 and SPR2 may include an outer side surface adjacent to the light-emitting element LD1 or LD2 and an inner side surface disposed in the spacer portion SPP. The first separator SPR1 may include a first side surface SS1 adjacent to the first light-emitting element LD1 and a second side surface SS2 disposed in the spacer portion SPP. The second separator SPR2 may include a third side surface SS3 adjacent to the second light-emitting element LD2 and a fourth side surface SS4 disposed in the spacer portion SPP. The second side surface SS2 and the fourth side surface SS4 may face each other with the spacer portion SPP interposed therebetween.

The connection electrodes CNE1 and CNE2 may be disposed on the outer side surfaces of the first and second separators SPR1 and SPR2 and need not be disposed on the inner side surfaces of the first and second separators SPR1 and SPR2. In an embodiment of the inventive concept, the first connection electrode CNE1 is disposed on the first side surface SS1 of the first separator SPR1 and is not disposed on the second side surface SS2. Consequently, the conductive material of the first connection electrode CNE1 exposes the second side surface. The second connection electrode CNE2 may be disposed on the third side surface SS3 of the second separator SPR2 and need not be disposed on the fourth side surface SS4. Figures 6, 7A, and 7B indicate the first and second connection electrodes CNE1, CNE2, being formed as a continuous layer on, a portion of the pixel defining film PDL, the outer side surfaces SS1 and SS3 of the first and second separators SPR1 and SPR2, and on a portion of an upper surface of the first and second separators SPR1, SPR2.

A separation distance S1 between the first and second separators SPR1 and SPR2 in a given direction is smaller than a separation distance S2 between the connection electrodes CNE1 and CNE2 in the same direction as the given direction. That is, the separation distance S2 between the end portions of the first connection electrode CNE1 and the second connection electrode CNE2 may be larger than the separation distance S1 between the first separator SPR1 and the second separator SPR2. Here, the end portions of the first connection electrode CNE1 and the second connection electrode CNE2 may correspond to the third connection portions CNE1-3 and CNE2-3. The separation distance S1 between the first separator SPR1 and the second separator SPR2 may correspond to the width of the spacer portion SPP. Meanwhile, the separation distance S2 between the end portions of the first connection electrode CNE1 and the second connection electrode CNE2 may be less than a separation distance S3 between the outer side surfaces SS1 and SS3 of the first separator SPR1 and the second separator SPR2, respectively.

The first light-emitting element LD1 may include a first lower electrode EL11, a first intermediate layer IML1, and a first upper electrode EL21. The second light-emitting element LD2 may include a second lower electrode EL12, a second intermediate layer IML2, and a second upper electrode EL22.

Each of the first lower electrode EL11 and the second lower electrode EL12 may be a semi-transmissive, transmissive, or reflective electrode. Each of the first lower electrode EL11 and the second lower electrode EL12 may include: a reflective layer formed of silver (Ag), magnesium (Mg), aluminum (Al), platinum (Pt), palladium (Pd), gold (Au), nickel (Ni). neodymium (Nd), iridium (Ir), or chromium (Cr), or a compound thereof; and a transparent or semi-transparent electrode layer formed on the reflective layer. The transparent or semi-transparent electrode layer may include at least one of indium tin oxide (ITO), indium zinc oxide (IZO), indium gallium zinc oxide (IGZO), zinc oxide (ZnO) or indium oxide (In₂O₃), or aluminum-doped zinc oxide (AZO). For example, each of the first lower electrode EL11 and the second lower electrode EL12 may include a stacked structure of ITO/Ag/ITO.

According to an embodiment, the first lower electrode EL11 may be the anode of the first light-emitting element LD1. The second lower electrode EL12 may be the anode of the second light-emitting element LD2. The first power voltage VDD (see FIG. 2A) may be applied to each of the first lower electrode EL11 and the second lower electrode EL12.

The first intermediate layer IML1 may be disposed between the first lower electrode EL11 and the first upper electrode EL21. The first intermediate layer IML1 may include a first light-emitting layer EML1 and a first functional layer FNL1. The second intermediate layer IML2 may be disposed between the second lower electrode EL12 and the second upper electrode EL22. The second intermediate layer IML2 may include a second light-emitting layer EML2 and a second functional layer FNL2. Each of the first light-emitting element LD1 and the second light-emitting element LD2 may include the intermediate layers IML1 and IML2 having various structures, and the inventive concept is not limited to any one embodiment.

The first functional layer FNL1 may be disposed between the first lower electrode EL11 and the first upper electrode EL21. The first functional layer FNL1 may include a first intermediate functional layer FNL11 disposed between the first lower electrode EL11 and the first light-emitting layer EML1 and a second intermediate functional layer FNL12 disposed between the first upper electrode EL21 and the first light-emitting layer EML1. The second functional layer FNL2 may be disposed between the second lower electrode EL12 and the second upper electrode EL22. The second functional layer FNL2 may include a third intermediate functional layer FNL21 disposed between the second lower electrode EL12 and the second light-emitting layer EML2 and a fourth intermediate functional layer FNL22 disposed between the second upper electrode EL22 and the second light-emitting layer EML2.

The first functional layer FNL1 and the second functional layer FNL2 may control the movement of charge between the lower electrodes EL11 and EL12 and the upper electrodes EL21 and EL22. For example, the first intermediate functional layer FNL11 and the third intermediate functional layer FNL21 may include a hole injection/transport material. The first intermediate functional layer FNL11 and the third intermediate functional layer FNL21 may include at least one of an electron blocking layer, a hole transport layer, or a hole injection layer. The second intermediate functional layer FNL12 and the fourth intermediate functional layer FNL22 may include an electron injection/transport material. The second intermediate functional layer FNL12 and the fourth intermediate functional layer FNL22 may include at least one of a hole blocking layer, an electron transport layer, or an electron injection layer.

Each of the first light-emitting layer EML1 and the second light-emitting layer EML2 may include an organic light-emitting material. In addition, each of the first light-emitting layer EML1 and the second light-emitting layer EML2 may include an inorganic light-emitting material, or may be provided as a mixed layer of an organic light-emitting material and an inorganic light-emitting material.

The first upper electrode EL21 may be disposed on the first intermediate layer IML1. The second upper electrode EL22 may be disposed on the second intermediate layer IML2. As described herein, each of the first upper electrode EL21 and the second upper electrode EL22 may be connected to the connection electrodes CNE1 and CNE2 and electrically connected to the pixel driver PDC. That is, each of the first upper electrode EL21 and the second upper electrode EL22 may be electrically connected to the connection transistor TR through the connection electrodes CNE1 and CNE2.

Dummy layers UP may be respectively disposed on the first and second separators SPR1 and SPR2. The dummy layers UP may include a first dummy layer UP1 disposed on the first separator SPR1 and a second dummy layer UP2 disposed on the first dummy layer UP1. The dummy layers UP may include a third dummy layer UP3 disposed on the second separator SPR2 and a fourth dummy layer UP4 disposed on the third dummy layer UP3. The first dummy layer UP1 may be formed through the same process as and with the inclusion of the same material as the first intermediate layer IML1. The third dummy layer UP3 may be formed through the same process as and with the inclusion of the same material as the second intermediate layer IML2. In an embodiment of the inventive concept, the first dummy layer UP1 and the third dummy layer UP3 may be formed simultaneously in a process of forming the functional layers FNL1 and FNL2. The second dummy layer UP2 may be formed through the same process as and with the inclusion of the same material as the first upper electrode EL21. The fourth dummy layer UP4 may be formed through the same process as and with the inclusion of the same material as the second upper electrode EL22. In an embodiment of the inventive concept, the second dummy layer UP2 and the fourth dummy layer UP4 may be formed simultaneously in a process of forming the upper electrodes EL21 and EL22.

The first dummy layer UP1 may include a (1-1)-th dummy layer UP1a and a (1-2)-th dummy layer UP1b. The (1-1)-th dummy layer UP1a may be formed through the same process as and with the inclusion of the same material as the first intermediate functional layer FNL11. The (1-2)-th dummy layer UP1b may be formed through the same process as and with the inclusion of the same material as the second intermediate functional layer FNL12. The third dummy layer UP3 may include a (3-1)-th dummy layer UP3a and a (3-2)-th dummy layer UP3b. The (3-1)-th dummy layer UP3a may be formed through the same process as and with the inclusion of the same material as the third intermediate functional layer FNL21. The (3-2)-th dummy layer UP3b may be formed through the same process as and with the inclusion of the same material as the fourth intermediate functional layer FNL22.

As illustrated in FIGS. 6, 7A, and 7B, each of the first separator SPR1 and the second separator SPR2 may have a double reverse taper shape. The side surfaces SS1, SS2, SS3, and SS4 of the first separator SPR1 and the second separator SPR2 may include a first sub-side surface and a second sub-side surface which respectively have different taper angles. The first side surface SS1 of the first separator SPR1 may include a (1-1)-th sub-side surface SS1a and a (2-1)-th sub-side surface SS1b which respectively have different taper angles. The second side surface SS2 of the first separator SPR1 may include a (1-2)-th sub-side surface SS2a and a (2-2)-th sub-side surface SS2b which respectively have different taper angles. The third side surface SS3 of the second separator SPR2 may include a (1-3)-th sub-side surface SS3a and a (2-3)-th sub-side surface SS3b which respective have different taper angles. The fourth side surface SS4 of the second separator SPR2 may include a (1-4)-th sub-side surface SS4a and a (2-4)-th sub-side surface SS4b which respectively have different taper angles. The second sub-side surfaces SS1b, SS2b, SS3b, and SS4b may be side surfaces adjacent to the upper surface of the pixel defining film PDL, and the first sub-side surfaces SS1a, SS2a, SS3a, and SS4a may be side surfaces spaced apart from the upper surface of the pixel defining film PDL with the second sub-side surfaces SS1b, SS2b, SS3b, and SS4b interposed therebetween.

The taper angles formed by the first sub-side surfaces SS1a, SS2a, SS3a, and SS4a and the taper angles formed by the second sub-side surfaces SS1b, SS2b, SS3b, and SS4b of the first separator SPR1 and the second separator SPR2 with respect to the upper surface of the pixel defining film PDL may be different from each other. Each of the taper angles may be an obtuse angle. For example, as in FIGS. 7A and 7B, the taper angle formed by the first sub-side surfaces SS1a, SS2a, SS3a, and SS4a with respect to the upper surface of the pixel defining film PDL may be greater than the taper angle formed by the second sub-side surfaces SS1b, SS2b, SS3b, and SS4b with respect to the upper surface of the pixel defining film PDL.

Meanwhile, in FIG. 6 and the like, the first and second separators SPR1 and SPR2 are exemplarily illustrated as having a double reverse taper shape, but without being limited thereto, the first and second separators SPR1 and SPR2 may have a single reverse taper shape in the display panel according to an embodiment of the inventive concept, which will be described later That is, the side surfaces SS1 to SS4 of the first and second separators SPR1 and SPR2 may include a surface having a constant taper angle.

The upper electrodes EL21 and EL22 come in contact with the connection electrodes CNE1 and CNE2 through the contact regions CA1 and CA2. The contact regions CA1 and CA2 may be provided to be adjacent to the first and second separators SPR1 and SPR2. In the contact regions CA1 and CA2, the upper surfaces of the connection electrodes CNE1 and CNE2 may be in contact with the lower surfaces of the upper electrodes EL21 and EL22. Meanwhile, in a case that the first and second separators SPR1 and SPR2 have a reverse taper shape and the contact regions CA1 and CA2 are provided to be adjacent to the first and second separators SPR1 and SPR2, at least portions of the contact regions CA1 and CA2 at which the upper electrodes EL21 and EL22 and the connection electrodes CNE1 and CNE2 are in contact with each other may be disposed below the outer side surfaces of the first and second separators SPR1 and SPR2.

Meanwhile, as described herein, in a case that the connection electrodes CNE1 and CNE2 are disposed on the outer side surfaces of the first and second separators SPR1 and SPR2 and are not disposed on the inner side surfaces of the first and second separators SPR1 and SPR2, the contact regions CA1 and CA2 may be provided to be adjacent to the outer side surfaces of the first and second separators SPR1 and SPR2 and may not be provided in portions adjacent to the inner side surfaces thereof. In an embodiment of the inventive concept, the first contact region CA1 may be provided to be adjacent to the first side surface SS1 of the first separator SPR1, and a spacer region SPA in which a separate connection electrode is not provided may be provided in a portion adjacent to the second side surface SS2. The second contact region CA2 may be provided to be adjacent to the third side surface SS3 of the second separator SPR2, and the spacer region SPA in which a separate connection electrode is not provided may be provided in a portion adjacent to the fourth side surface SS4.

The display panel according to an embodiment of the inventive concept may include intermediate regions MA1 and MA2 respectively adjacent to the contact regions CA1 and CA2. In the intermediate regions MA1 and MA2, the functional layers FNL1 and FNL2 may be disposed between the connection electrodes CNE1 and CNE2 and the upper electrodes EL21 and EL22. That is, in the intermediate regions MA1 and MA2, the connection electrodes CNE1 and CNE2 and the upper electrodes EL21 and EL22 may be spaced apart from each other with the functional layers FNL1 and FNL2 interposed therebetween. The first intermediate functional layer FNL11 and the second intermediate functional layer FNL12 may be disposed in the first intermediate region MA1. The third intermediate functional layer FNL21 and the fourth intermediate functional layer FNL22 may be disposed in the second intermediate region MA2.

An additional dummy layer AP may be provided in the spacer portion SPP. The additional dummy layer AP may include a first additional dummy layer AP1 and a second additional dummy layer AP2. The first additional dummy layer AP1 may be disposed directly on the pixel defining film PDL. The second additional dummy layer AP2 may be disposed directly on the first additional dummy layer AP1. A region in which the additional dummy layer AP is disposed may correspond to the aforementioned spacer region SPA. The first additional dummy layer AP1 may include a (1-1)-th additional dummy layer AP1a and a (1-2)-th additional dummy layer AP1b.

In an embodiment of the inventive concept, the first additional dummy layer AP1 may be formed simultaneously in a process of forming the functional layers FNL1 and FNL2. The first additional dummy layer AP1 may be formed through the same process as and with the inclusion of the same material as the functional layers FNL1 and FNL2, the first dummy layer UP1, and the third dummy layer UP3. The (1-1)-th additional dummy layer AP1a may be formed through the same process as and with the inclusion of the same material as the first intermediate functional layer FNL11 and the third intermediate functional layer FNL21. The (1-2)-th additional dummy layer AP1b may be formed through the same process as and with the inclusion of the same material as the second intermediate functional layer FNL12 and the fourth intermediate functional layer FNL22.

In an embodiment of the inventive concept, the second additional dummy layer AP2 may be formed simultaneously in a process of forming the upper electrodes EL21 and EL22. The second additional dummy layer AP2 may be formed through the same process as and with the inclusion of the same material as the upper electrodes EL21 and EL22, the second dummy layer UP2, and the fourth dummy layer UP4. The second additional dummy layer AP2 may be disposed on portions of the inner side surfaces of the first and second separators SPR1 and SPR2. The second additional dummy layer AP2 may be disposed on a portion of each of the second side surface SS2 of the first separator SPR1 and the fourth side surface SS4 of the second separator SPR2.

A disconnection region may be formed when depositing the material forming the second additional dummy layer AP2 and the upper electrodes EL21 and EL22. The disconnection region may be a void in the material that separates the second additional dummy layer AP2 and the upper electrodes EL21 and EL22. For example, the second side surface SS2 of the first separator SPR1 and the fourth side surface SS4 of the second separator SPR2 may be exposed by the material forming the second additional dummy layer AP2 and the upper electrodes EL21 and EL22.

The connection electrodes CNE1 and CNE2 include portions disposed in the contact regions CA1 and CA2 and portions disposed on the outer side surfaces SS1 and SS3 of the first and second separators SPR1 and SPR2. The connection electrodes CNE1 and CNE2 may include first connection portions CNE1-1 and CNE2-1 disposed in the contact regions CA1 and CA2 and second connection portions CNE1-2 and CNE2-2 disposed on the outer side surfaces SS1 and SS3 of the first and second separators SPR1 and SPR2. The second connection portions CNE1-2 and CNE2-2 may come in contact with the outer side surfaces SS1 and SS3 of the first and second separators SPR1 and SPR2. The second connection portions CNE1-2 and CNE2-2 may come in contact with the second sub-side surfaces SS1b and SS3b among the outer side surfaces SS1 and SS3 of the first and second separators SPR1 and SPR2 and at least portions of the first sub-side surfaces SS1a and SS3a.

The upper electrodes EL21 and EL22 may include portions in contact with the connection electrodes CNE1 and CNE2 in the contact regions CA1 and CA2 and portions in contact with portions of the connection electrodes CNE1 and CNE2 disposed on the outer side surfaces SS1 and SS3 of the first and second separators SPR1 and SPR2. The upper electrodes EL21 and EL22 may include first upper electrode portions EL21-1 and EL22-1 disposed on the first connection portions CNE1-1 and CNE2-1 and second upper electrode portions EL21-2 and EL22-2 in contact with the side surfaces of the second connection portions CNE1-2 and CNE2-2.

In an embodiment of the inventive concept, the first and second separators SPR1 and SPR2 may be formed first, and then the connection electrodes CNE1 and CNE2 may be formed through a subsequent process, so that portions of the connection electrodes CNE1 and CNE2 may have a shape in which they are not disposed below the first and second separators SPR1 and SPR2, but are disposed along the outer side surfaces SS1 and SS3. Accordingly, as the connection electrodes CNE1 and CNE2 and the upper electrodes EL21 and EL22 additionally come in contact with each other on the outer side surfaces SS1 and SS3 of the first and second separators SPR1 and SPR2 in addition to the contact regions CA1 and CA2, the contact regions between the connection electrodes CNE1 and CNE2 and the upper electrodes EL21 and EL22 may increase. That is, as the area of the connection contact increases, the connection may be stably maintained.

In an embodiment of the inventive concept, portions of the connection electrodes CNE1 and CNE2 may be disposed on the first and second separators SPR1 and SPR2. The connection electrodes CNE1 and CNE2 may further include third connection portions CNE1-3 and CNE2-3 disposed on portions of the upper surfaces SPR1-U and SPR2-U of the first and second separators SPR1 and SPR2. In an embodiment of the inventive concept, the second connection portions CNE1-2 and CNE2-2 of the connection electrodes CNE1 and CNE2 may cover an entirety of the outer side surfaces SS1 and SS3 of the first and second separators SPR1 and SPR2 and may be connected to the third connection portions CNE1-3 and CNE2-3 disposed on portions of the upper surfaces SPR1-U and SPR2-U of the first and second separators SPR1 and SPR2.

In the case that the second connection portions CNE1-2 and CNE2-2 cover the outer side surfaces SS1 and SS3 of the first and second separators SPR1 and SPR2 and the third connection portions CNE1-3 and CNE2-3 are disposed on portions of the upper surfaces SPR1-U and SPR2-U of the first and second separators SPR1 and SPR2, the third connection portions CNE1-3 and CNE2-3 may be end portions of the connection electrodes CNE1 and CNE2, respectively, and the second side surface SS2 of the first separator SPR1 and the fourth side surface SS4 of the second separator SPR2 may be exposed.

Meanwhile, at least portions of the second connection portions CNE1-2 and CNE2-2 need not be in contact with the upper electrodes EL21 and EL22. The second upper electrode portions EL21-2 and EL22-2 may be disposed to correspond to first portions of the outer side surfaces SS1 and SS3 of the first and second separators SPR1 and SPR2 that expose second portions of the outer side surfaces SS1 and SS3 of the first and second separators SPR1 and SPR2. The second portions of the side surfaces of the second connection portions CNE1-2 and CNE2-2 may be exposed without being covered by the second upper electrode portions EL21-2 and EL22-2.

The dummy layer UP may be formed on the upper surfaces of the first and second separators SPR1 and SPR2 and on portions of the side surfaces SS1 to SS4. The dummy layer UP may not be in contact with the upper electrodes EL21 and EL22. For example, the disconnection region may be formed when depositing the material forming the dummy layer UP and the upper electrodes EL21 and EL22. The disconnection region may be a void in the material that separates the dummy layer UP and the upper electrodes EL21 and EL22.

In a given direction, the separation distance between the dummy layers disposed on the first and second separators SPR1 and SPR2 may be smaller than or equal to the separation distance between the first and second separators SPR1 and SPR2. In an embodiment of the inventive concept, the separation distance between the first dummy layer UP1 and the third dummy layer UP3 may be smaller than or equal to the separation distance S1 between the first separator SPR1 and the second separator SPR2. The separation distance between the second dummy layer UP2 and the fourth dummy layer UP4 may be smaller than or equal to the separation distance S1 between the first separator SPR1 and the second separator SPR2. The separation distance between the first dummy layer UP1 and the third dummy layer UP3 may be smaller than the separation distance S2 between the end portion of the first connection electrode CNE1 and the second connection electrode CNE2. The separation distance between the second dummy layer UP2 and the fourth dummy layer UP4 may be smaller than the separation distance S2 between the end portions of the first connection electrode CNE1 and the second connection electrode CNE2.

Meanwhile, a portion of the dummy layer UP may be in contact with the connection electrodes CNE1 and CNE2. The second dummy layer UP2 may be in contact with the first connection electrode CNE1 disposed on the first side surface SS1. The fourth dummy layer UP4 may be in contact with the second connection electrode CNE2 disposed on the third side surface SS3. In the display panel according to an embodiment of the inventive concept, even though a portion of the dummy layer UP may be in contact with the connection electrodes CNE1 and CNE2, a spacer portion SPP may be provided between adjacent separators SPR1 and SPR2, thereby preventing leakage current from occurring between adjacent pixels.

More specifically, the first inorganic layer IL1 may be directly disposed on the second connection portion CNE1-2 on the first side surface SS1 of the first separator SPR1, the second dummy layer UP2 on the first separator SPR1, and the inner side surface SS2 of the first separator SPR1, and directly disposed on the second connection portion CNE2-2 on the third side surface SS2 of the second separator SPR2, the third dummy layer UP3 on the second separator SPR2, and the inner side surface SS4 of the second separator SPR2.

More specifically, in the display panel according to an embodiment of the inventive concept, in a case that a transparent conductive oxide (TCO) included in the connection electrodes CNE1 and CNE2 has excellent deposition characteristics, portions of the outer side surfaces SS1 and SS3 and upper surfaces SPR1-U and SPR2-U of the first and second separators SPR1 and SPR2 may have a deposited structure. Meanwhile, in a case that a spacer portion SPP is provided between the first and second separators SPR1 and SPR2 and the connection electrodes CNE1 and CNE2 are not provided on the inner side surfaces SS2 and SS4 of the first and second separators SPR1 and SPR2, the inner side surfaces SS2 and SS4 may be disposed in the spacer portion SPP and may have an electrically disconnected structure. Therefore, in the display panel according to an embodiment of the inventive concept, even though a portion of the dummy layer UP may be in contact with the connection electrodes CNE1 and CNE2 and a leakage current may occur between the dummy layer UP and the connection electrodes CNE1 and CNE2, it is possible to inhibit or prevent lateral leakage current from occurring between pixels because the inner side surfaces SS2 and SS4 have an electrically disconnected structure.

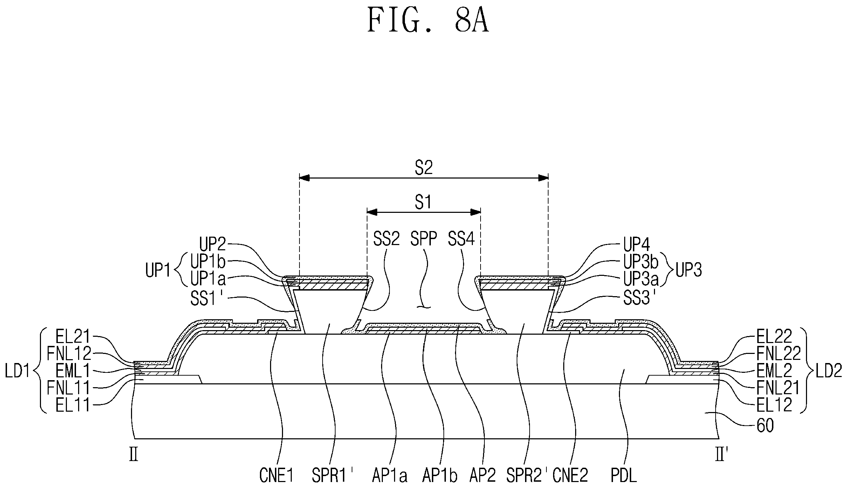

FIGS. 8A to 8C are cross-sectional views of a display panel according to an embodiment of the inventive concept. Each of FIGS. 8A to 8C illustrates a cross section of a display panel according to an embodiment of the inventive concept, which corresponds to the cross section illustrated in FIG. 6 and is different from embodiments illustrated in FIG. 6. Meanwhile, the same reference numerals will be given to the same components as those described herein with reference to FIGS. 5 and 6, and the detailed descriptions thereof will be omitted.

Referring to FIG. 8A, the outer side surfaces SS1' and SS3' of separators SPR1' and SPR2' according to an embodiment of the inventive concept may have a single reverse taper shape, not a double reverse taper shape. As illustrated in FIG. 8A, the outer side surfaces SS1' and SS3' of the separators SPR1' and SPR2' may have a reverse taper shape having a constant angle. A first separator SPR1' may include a first side surface SS1' having a single reverse taper shape, and a second separator SPR2' may include a third side surface SS3' having a single reverse taper shape.

In the separators SPR1' and SPR2' according to an embodiment of the inventive concept, the outer side surfaces SS1' and SS3' and the inner side surfaces SS2 and SS4 may have different shapes. As described herein, the inner side surfaces SS2 and SS4 of the separator SPR1' and SPR2' may have a double reverse taper shape, and the outer side surfaces SS1' and SS3' may have a single reverse taper shape having a constant angle. Without being limited thereto, however, the inner side surfaces SS2 and SS4 of the separator SPR1' and SPR2' may also have a single reverse taper shape having a constant angle like the outer side surfaces SS1' and SS3'.

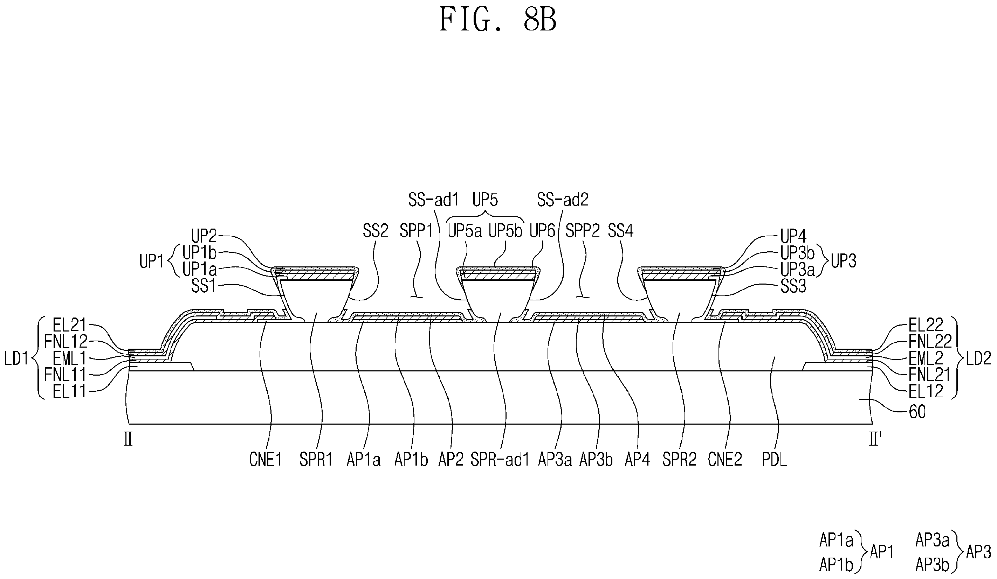

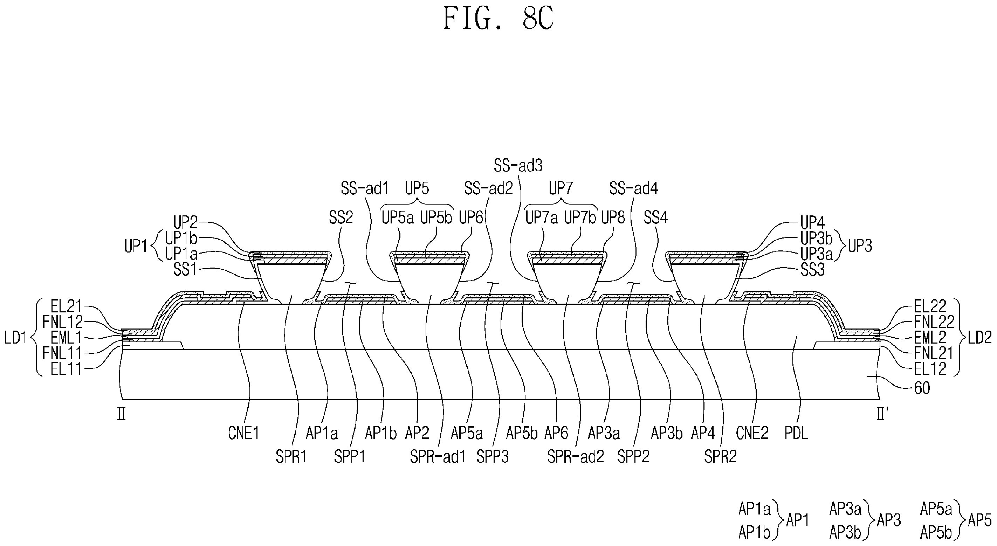

Referring to FIGS. 8B and 8C, additional separators SPR-ad1 and SPR-ad2 may be provided in a spacer portion between the first and second separators SPR1 and SPR2 according to an embodiment of the inventive concept. As illustrated in FIG. 8B, an additional separator SPR-ad1 may be provided in the spacer portion. Alternatively, as illustrated in FIG. 8C, a plurality of additional separators SPR-ad1 and SPR-ad2 may be provided in the spacer portion. A first additional separator SPR-ad1 and a second additional separator SPR-ad2 may be provided in the spacer portion.

The additional separators SPR-ad1 and SPR-ad2 may have the same shape as the first and second separators SPR1 and SPR2. The additional separators SPR-ad1 and SPR-ad2 may have a reverse taper shape. That is, the additional separators SPR-ad1 and SPR-ad2 may have a shape having a width that increases with height away from the upper surface of the pixel defining film PDL. The additional separators SPR-ad1 and SPR-ad2 may have a double reverse taper shape. The first additional separator SPR-ad1 may include a first additional side surface SS-ad1 and a second additional side surface SS-ad2 which have a reverse taper shape. The second additional separator SPR-ad2 may include a third additional side surface SS-ad3 and a fourth additional side surface SS-ad4 which have a reverse taper shape.

The dummy layer UP may be provided on the first and second separators SPR1 and SPR2 and on the additional separators SPR-ad1 and SPR-ad2. The dummy layer UP may include a fifth dummy layer UP5 disposed on the first additional separator SPR-ad1 and a sixth dummy layer UP6 disposed on the fifth dummy layer UP5. The dummy layer UP may include a seventh dummy layer UP7 disposed on the second additional separator SPR-ad2 and an eighth dummy layer UP8 disposed on the seventh dummy layer UP7. In an embodiment of the inventive concept, the fifth dummy layer UP5 and the seventh dummy layer UP7 may be formed simultaneously in a process of forming the functional layers FNL1 and FNL2. In an embodiment of the inventive concept, the sixth dummy layer UP6 and the eighth dummy layer UP8 may be formed simultaneously in a process of forming the upper electrodes EL21 and EL22.

The fifth dummy layer UP5 may include a (5-1)-th dummy layer UP5a and a (5-2)-th dummy layer UP5b. The (5-1)-th dummy layer UP5a may be formed through the same process as and with the inclusion of the same material as the first intermediate functional layer FNL11. The (5-2)-th dummy layer UP5b may be formed through the same process as and with the inclusion of the same material as the second intermediate functional layer FNL12. The seventh dummy layer UP7 may include a (7-1)-th dummy layer UP7a and a (7-2)-th dummy layer UP7b. The (7-1)-th dummy layer UP7a may be formed through the same process as and with the inclusion of the same material as the third intermediate functional layer FNL21. The (7-2)-th dummy layer UP7b may be formed through the same process as and with the inclusion of the same material as the fourth intermediate functional layer FNL22.

A sub-spacer portion may be provided between the first and second separators SPR1 and SPR2 and the adjacent additional separators SPR-ad1 and SPR-ad2. When an additional separator SPR-ad1 is provided as in FIG. 8B, a first sub-spacer portion SPP1 may be provided between the first separator SPR1 and the first additional separator SPR-ad1, and a second sub-spacer portion SPP2 may be provided between the second separator SPR2 and the first additional separator SPR-ad1. When the first additional separator SPR-ad1 and the second additional separator SPR-ad2 are provided as in FIG. 8C, a first sub-spacer portion SPP1 may be provided between the first separator SPR1 and the first additional separator SPR-ad1, a second sub-spacer portion SPP2 may be provided between the second separator SPR2 and the second additional separator SPR-ad2, and a third sub-spacer portion SPP3 may be provided between the first additional separator SPR-ad1 and the second additional separator SPR-ad2.

The aforementioned additional dummy layer may be provided to each of the sub-spacer portions SPP1, SPP2, and SPP3.

When an additional separator SPR-ad1 is provided as in FIG. 8B, a first additional dummy layer AP1 and a second additional dummy layer AP2 may be provided in the first sub-spacer portion SPP1. The first additional dummy layer AP1 may include a (1-1)-th additional dummy layer AP1a and a (1-2)-th additional dummy layer AP1b. The second sub-spacer portion SPP2 may include a third additional dummy layer AP3 and a fourth additional dummy layer AP4. The third additional dummy layer AP3 may include a (3-1)-th additional dummy layer AP3a and a (3-2)-th additional dummy layer AP3b. The second additional dummy layer AP2 may be disposed on a portion of each of the second side surface SS2 of the first separator SPR1 and the first additional side surface SS-ad1 of the first additional separator SPR-ad1. The fourth additional dummy layer AP4 may be disposed on a portion of each of the fourth side surface SS4 of the second separator SPR2 and the second additional side SS-ad2 of the first additional separator SPR-ad1.

When the first additional separator SPR-ad1 and the second additional separator SPR-ad2 are provided as illustrated in FIG. 8C, a first additional dummy layer AP1 and a second additional dummy layer AP2 may be provided in the first sub-spacer portion SPP1. The first additional dummy layer AP1 may include a (1-1)-th additional dummy layer AP1a and a (1-2)-th additional dummy layer AP1b. A third additional dummy layer AP3 and a fourth additional dummy layer AP4 may be provided in the second sub-spacer portion SPP2. The third additional dummy layer AP3 may include a (3-1)-th additional dummy layer AP3a and a (3-2)-th additional dummy layer AP3b. A fifth additional dummy layer AP5 and a sixth additional dummy layer AP6 may be provided in the third sub-spacer portion SPP3. The fifth additional dummy layer AP5 may include a (5-1)-th additional dummy layer AP5a and a (5-2)-th additional dummy layer AP5b. The second additional dummy layer AP2 may be disposed on a portion of each of the second side surface SS2 of the first separator SPR1 and the first additional side surface SS-ad1 of the first additional separator SPR-ad1. The fourth additional dummy layer AP4 may be disposed on a portion of each of the fourth side surface SS4 of the second separator SPR2 and the fourth additional side surface SS-ad4 of the second additional separator SPR-ad2. The sixth additional dummy layer AP6 may be disposed on a portion of each of the second additional side surface SS-ad2 of the first additional separator SPR-ad1 and the third additional side surface SS-ad3 of the second additional separator SPR-ad2.

Each of the first additional dummy layer AP1, the third additional dummy layer AP3, and the fifth additional dummy layer AP5 may be formed simultaneously in a process of forming the functional layers FNL1 and FNL2 and include the same material as the functional layers FNL1 and FNL2. Each of the second additional dummy layer AP2, the fourth additional dummy layer AP4, and the sixth additional dummy layer AP6 may be formed simultaneously in a process of forming the upper electrodes EL21 and EL22 and include the same material as the upper electrodes EL21 and EL22.

According to the description, in the display panel according to an embodiment of the inventive concept, the connection electrode electrically connected to the cathode of the light-emitting element and the pixel driving circuit is in contact with a region adjacent to the separator provided for pixel division and a side surface of the separator, and therefore, connection may be made over a relatively wide region, thereby improving contact reliability. Meanwhile, as the display panel according to an embodiment of the inventive concept includes a plurality of separators provided between adjacent pixels and a spacer portion provided between the separators, leakage current between the adjacent pixels may be prevented from occurring.

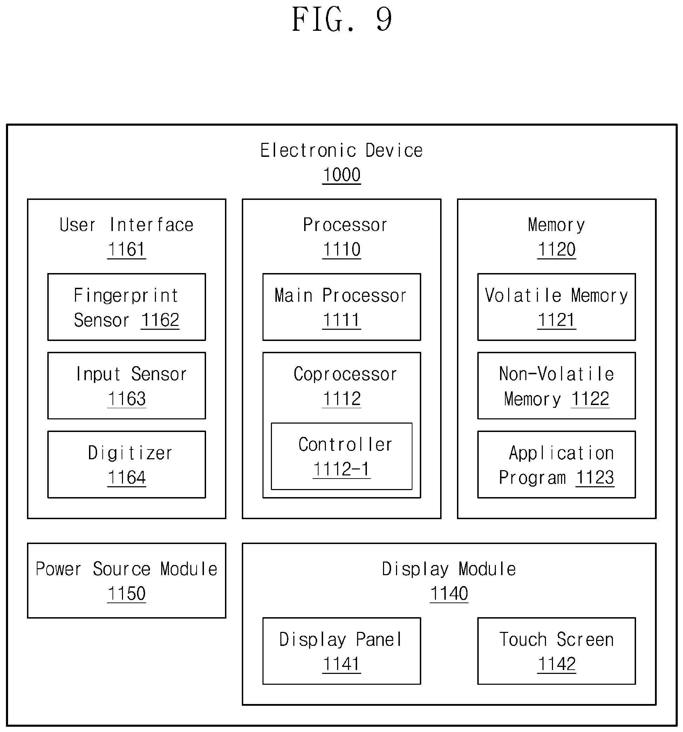

FIG. 9 is a diagram illustrating an electronic device according to an embodiment of the present invention. Referring to FIG. 9, the electronic device 1000 according to one embodiment of the present invention may output various information (e.g., images, text, music, etc.) through a display module 1140, which, for example, may correspond to the display device DD shown in FIG. 1. When a processor 1110 executes an application stored in a memory 1120, the display module 1140 may provide application information to a user through a display panel 1141.

In some embodiments, the electronic device 1000 may be configured as a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some embodiments, memory 1120 may store information such as software codes for operating an application program 1123. The application program 1123 may include a software designed to execute specific tasks or provide functionality to a user. The application program 1123 may operate under the control of the processor 1110 and utilizes data stored in the memory 1120 to deliver a wide range of features, such as productivity tools, multimedia streaming and playback, file or mail deliveries or communication services. The application program 1123 interacts seamlessly with the user interface 1161 or touch screen 1142, allowing a user to launch, navigate, and utilize the program through user inputs such as touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

As another example, when a user wishes to make a phone call, the user taps the telephone icon displayed on the display module 1140, the processor 1110 may execute a phone application program stored in the memory 1120. A telephone keypad may be presented on the display panel 1141 for the user to enter a phone number to call.

As another example, the display module 1140 may be integrated into an electronic device 1000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and nonvolatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device DD shown in FIG. 1.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as blood pressure, moisture, or body mass.

The input sensor 1163 may sense user interactions including touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 includes touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include a liquid crystal display panel, an organic light emitting display panel, or an inorganic light emitting display panel, and the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display device DD shown in FIG. 1.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power source to each of the components described above including the display module 1140.

Although aspects of the inventive concept have described with reference to preferred embodiments, those skilled in the art or those of ordinary skill in the art will understand that various modifications and changes can be made to the inventive concept within the scope that does not depart from the spirit and technical field of the inventive concept described in the claims to be described later. Accordingly, the technical scope of the inventive concept should not be limited to the content described in the detailed description of the specification, but should be determined by the claims described hereinafter.

## Claims

1. A display panel comprising:
a driving element layer (DDL) comprising a pixel driver (PDC);
a first light-emitting element (LD1) disposed on the driving element layer (DDL) and comprising, a first lower electrode (EL11), a first intermediate layer (IML1) disposed on the first lower electrode (EL11) and including at least a first light-emitting layer (EML1), and a first upper electrode (EL21) disposed on the first intermediate layer (IML1);
a pixel defining film (PDL) disposed on the driving element layer (DDL) and having a first opening (OP-PDL1) defined therein and exposing at least a portion of the first lower electrode; (EL11)
a first connection electrode (CNE1) formed of a conductive material and disposed on the pixel defining film (PDL) and electrically connected to the pixel driver (PDC) and the first upper electrode (EL21);
a first separator (SPR1) disposed on the pixel defining film (PDL) and adjacent to the first light-emitting element (LD1); and
a second separator (SPR2) disposed on the pixel defining film (PDL) and spaced apart from the first separator (SPR1),
wherein:
the first separator (SPR1) comprises a first side surface (SS1) adjacent to the first light-emitting element (LD1) and a second side surface (SS2) facing the second separator (SPR2),
the first connection electrode (CNE1) is disposed on at least a portion of the first side surface (SS1), and
the conductive material exposes the second side surface.

2. The display panel of claim 1, further comprising a second light-emitting element (LD2) disposed on the driving element layer (DDL) and comprising:
a second lower electrode (EL12);
a second intermediate layer (IML2) disposed on the second lower electrode (EL12) and including at least a second light-emitting layer (EML2); and
a second upper electrode (EL22) disposed on the second intermediate layer (IML2), wherein the second separator (SPR2) is disposed between the second light-emitting element (LD2) and the first separator (SPR1) on a plane, optionally wherein:
a second opening (OP-PDL2) exposing at least a portion of the second lower electrode (EL12) is defined in the pixel defining film (PDL); and
the display panel (DP) further comprises a second connection electrode (CNE2) formed of the conductive material, disposed on the pixel defining film (PDL) and electrically connected to the pixel driver (PDC) and the second upper electrode (EL22).

3. The display panel of claim 2, wherein:
the second separator (SPR2) comprises a third side surface (SS3) adjacent to the second light-emitting element (LD2) and a fourth side surface (SS4) facing the first separator (SPR1),
the second connection electrode (CNE2) is disposed on at least a portion of the third side surface (SS3),
the conductive material exposes the fourth side surface (SS4), and
the conductive material exposes a spacer portion (SPP) disposed between the first separator (SPR1) and the second separator (SPR2, optionally wherein each of the first connection electrode (CNE1) and the second connection electrode (CNE2) apart from the spacer portion (SPP) in a plan view.

4. The display panel of claim 1, 2 or 3, wherein the first intermediate layer (IML1) further comprises a first functional layer (FNL1),
wherein:
the first functional layer (FNL1) comprises a first intermediate functional (FNL11) layer disposed on the first lower electrode (ELL1) and a second intermediate functional layer (FNL12) disposed on the first light-emitting layer (EML1); and the first light-emitting layer (EML1) is disposed between the first intermediate functional layer (FNL11) and the second intermediate functional layer (FNL12)., optionally further comprising:
a first dummy layer (UP1) disposed on the first separator (SPR1) and including the same material as the first functional layer (FNL1); and
a second dummy layer (UP2) disposed on the first dummy layer (UP1) and including the same material as the first upper electrode (EL21),
wherein the first connection electrode (CNE1) is in contact with the second dummy layer (UP2).

5. The display panel of claim 4, further comprising:
a first additional dummy layer (AP1) disposed in a spacer portion (SPP) defined between the first separator (SPR1) and the second separator (SPR2) and including the same material as the first functional layer (FNL1); and
a second additional dummy layer (AP2) disposed on the first additional dummy layer (AP1) and including the same material as the first upper electrode (EL21).

6. The display panel of any one of claims 1 to 5, wherein the first connection electrode (CNE1) has a ring shape surrounding the first opening (OP-PDL1).

7. The display panel of any one of claims 1 to 6, wherein, in a first contact region (CA1) adjacent to the first separator (SPR1), the lower surface of the first upper electrode (EL21) is in contact with the upper surface of the first connection electrode (CNE1), optionally wherein the first connection electrode (CNE1) comprises:
a first connection portion (CNE1-1) disposed in the first contact region (CA1);
a second connection portion (CNE1-2) disposed on the first side surface (SS1) of the first separator (SPR1); and
a third connection portion (CNE1-3) disposed on the upper surface of the first separator (SPR1), and/ or wherein the first upper electrode comprises (EL21):
a first upper electrode portion (EL21-1) in contact with the upper surface of the first connection portion (CNE1-1); and
a second upper electrode portion (EL21-2) in contact with a side surface of the second connection portion (CNE1-2).

8. The display panel of any one of claims 1 to 7, further comprising an additional separator (SPR-ad1, SPR-ad2) disposed between the first separator (SPR1) and the second separator (SPR2),
wherein the additional separator (SPR-ad1, SPR-ad2) is spaced apart from each of the first separator (SPR1) and the second separator (SPR2).

9. The display panel of any one of claims 1 to 8, wherein:
a through hole (OP-P) is defined in the pixel defining film (PDL); and
the first connection electrode (CNE1) is connected to the pixel driver (PDC) through the through hole (OP-P), optionally wherein the first intermediate layer (IML1) overlaps the through hole (OP-P).

10. The display panel of any one of claims 1 to 9, wherein, in an intermediate region (MA1) disposed between the first separator (SPR) and the first light-emitting element (LD1), the first intermediate layer (IML1) is disposed between the first connection electrode (CNE1) and the first upper electrode (EL21).

11. A display panel comprising:
a driving element layer (DDL) comprising a pixel driver (PDC);
a first light-emitting element (LD1) disposed on the driving element layer (DDL) and comprising a first lower electrode (EL11), a first intermediate layer (IML1) disposed on the first lower electrode (EL11) and including at least a first light-emitting layer (EML1), and a first upper electrode (EL21) disposed on the first intermediate layer (IML1);
a second light-emitting element (LD2) disposed on the driving element layer (DDL) and comprising a second lower electrode (EL12), a second intermediate layer (IML2) disposed on the second lower electrode (EL12) and including at least a second light-emitting layer (EML2), and a second upper electrode (EL22) disposed on the second intermediate layer (IML2);
a pixel defining film (PDL) disposed on the driving element layer (DDL) and having a first opening defined (OP-PDL1) therein and exposing at least a portion of the first lower electrode (EL11) and a second opening (OP-PDL2) defined therein and exposing at least a portion of the second lower electrode EL12);
a first connection electrode (CNE1) disposed on the pixel defining film (PDL) and electrically connected to the pixel driver (PDC) and the first upper electrode (EL21);
a second connection electrode (CNE2) disposed on the pixel defining film (PDL) and electrically connected to the pixel driver (PDC) and the second upper electrode (EL22); and
a separator (SPR) disposed on the pixel defining film (PDL) and comprising a first separator (SPR1) adjacent to the first light-emitting element (LD1) and a second separator (SPR2) adjacent to the second light-emitting element (LD2),
wherein a separation distance (S1) between the first separator (SPR) and the second separator (SPR2) is smaller than a separation distance (S2) between the first connection electrode (CNE1) and the second connection electrode (CNE2).

12. The display panel of claim 11, wherein the first intermediate layer (IML1) further comprises a first functional layer (FNL1).
wherein:
the first functional layer (FNL1) comprises a first intermediate functional layer (FNL11) disposed on the first lower electrode (EL11) and a second intermediate functional layer (FNL12) disposed on the first light-emitting layer (EML1);
the first light-emitting layer (EML1) is disposed between the first intermediate functional layer (FNL11) and the second intermediate functional layer (FNL12); and
the second intermediate layer (IML2) further comprises a second functional layer (FNL2),
wherein:
the second functional layer (FNL2) comprises a third intermediate functional layer (FNL21) disposed on the second lower electrode (EL 12) and a fourth intermediate functional layer (FNL22) disposed on the second light-emitting layer (EML2); and
the second light-emitting layer (EML2) is disposed between the third intermediate functional layer (FNL21) and the fourth intermediate functional layer (FNL22), optionally further comprising:
a first dummy layer (UP1) disposed on the first separator (SPR1) and including the same material as the first functional layer (FNL1);
a second dummy layer (UP2) disposed on the first dummy layer (UP1) and including the same material as the first upper electrode (EL21);
a third dummy layer (UP3) disposed on the second separator (SPR2) and including the same material as the second functional layer (FNL2); and
a fourth dummy layer (UP4) disposed on the third dummy layer (UP3) and including the same material as the second upper electrode (EL22),
wherein:
the first connection electrode (CNE1) is in contact with the second dummy layer (UP2); and
the second connection electrode (CNE2) is in contact with the fourth dummy layer (UP4).

13. The display panel of claim 12, wherein a separation distance between the second dummy layer (UP2) and the fourth dummy layer (UP4) is smaller than a separation distance (S2) between the first connection electrode (CNE1) and the second connection electrode (CNE2), and
wherein the separation distance (S2) between the first connection electrode (CNE1) and the second connection electrode (CNE2) is less than a separation distance (S3) between an outer side surface (SS1) of the first separator (SPR1) and an outer side surface (S3) of the second separator (SPR2), optionally wherein each of the first connection electrode (CNE1) and the second connection electrode (CNE2) are formed of a conductive material not disposed in a spacer portion (SPP) between the first separator (SPR1) and the second separator (SPR2).

14. The display panel of claim 12 or 13, further comprising:
a first additional dummy layer (AP1) disposed between the first separator (SPR1) and the second separator (SPR2) and including the same material as each of the first functional layer (FNL1) and the second functional layer (FNL2); and
a second additional dummy layer (AP2) disposed on the first additional dummy layer (AP1) and including the same material as each of the first upper electrode (EL21) and the second upper electrode (EL22).

15. An electronic device comprising:
a processor (1110);
a memory (1120) having stored application programs (1123) for execution by the processor (1110);
a display device (DD) including a display panel (DP) as claimed in any one of claims 1 to 14; and
an user interface configured to sense user input via touch or cursor select of an icon presented on the display device, wherein the processor is caused to execute one or more of the stored application programs upon receipt of the user input.
